# EUROPEAN PATENT SPECIFICATION

(11) **EP 2 652 485 B1**
(45) Date of publication and mention of the grant of the patent: **24.05.2017**
(21) Application number: 11848482.3
(22) Date of filing: 16.02.2011
(51) Int. Cl.: G21K 1/08, H01J 37/141, H01J 37/28

(54) **APPARATUS OF PLURAL CHARGED PARTICLE BEAMS WITH MULTI-AXIS MAGNETIC LENS**
VORRICHTUNG MIT MEHREREN GELADENEN TEILCHENSTRAHLEN UND EINER MEHRACHSIGEN MAGNETISCHEN LINSE
APPAREIL COMPORTANT UNE PLURALITÉ DE FAISCEAUX DE PARTICULES CHARGÉES AVEC LENTILLE MAGNÉTIQUE MULTIAXIALE

(30) Priority: 14.12.2010 US 968221
(43) Date of publication of application: 23.10.2013
(73) Proprietor: Hermes-Microvision, Inc., Hsinchu 300 (TW)
(72) Inventor: CHEN, Zhongwei, San Jose, CA 95129 (US); REN, Weiming, San Jose, CA 95131 (US); KANAI, Kenichi, Palo Aito, CA 94303 (US); LIU, Xuedong, Cupertino, CA 95014 (US)
(74) Representative: Karakatsanis, Georgios
(86) International application number: PCT/US2011/025100
(87) International publication number: WO 2012/082171

(56) References cited:
- WO-A1-2011/071549
- DE-A1- 3 010 814
- US-A- 4 544 846
- US-A- 5 912 469
- US-A1- 2001 028 046
- US-B1- 6 344 114
- US-B2- 6 703 624
- US-B2- 6 750 455
- US-B2- 6 777 694
- US-B2- 7 230 257
- US-B2- 7 253 417

## Description

### CROSS-REFERENCE TO RELATED APPLICATIONS

This application relates to co-pending U.S. Application No. 12/636,007, filed on December 11, 2009 and entitled "A MULTI-AXIS MAGNETIC LENS" (now US 8,003,953). The foregoing application is commonly assigned.

### FIELD OF THE INVENTION

The present invention relates to a multi-axis magnetic immersion objective lens. More specifically, it relates to a multi-axis charged particle apparatus for obtaining a high spatial resolution and a high throughput in defect inspection of semiconductor wafer and mask.

### BACKGROUND OF THE INVENTION

Defect inspection of semiconductor wafer and mask in IC manufacturing is an accepted significant production process for yield enhancement. The information obtained from a wafer defect inspection tool can be used to flag defective dies for repair, or improve wafer processing parameters. There are two main kinds of inspection tools used for defect inspection in semiconductor fabrication plants, i.e., optical inspection tool and electron beam inspection tool. The spatial resolution of an optical inspection tool is fundamentally limited by its larger wave diffraction spot because an optical wavelength is much longer than that of an electron beam. As critical dimensions of patterns on a wafer and a mask are required to become smaller and smaller, it is becoming incompetent. However, the throughput or called as inspection speed of an electron beam inspection tool is fundamentally limited by electron interaction or called as Coulomb Effect. As inspecting full wafer or full mask is becoming necessary, increasing its throughput is becoming a key issue. As a promising solution, using a plurality of electron beams to inspect wafer in parallel was provided many years ago.

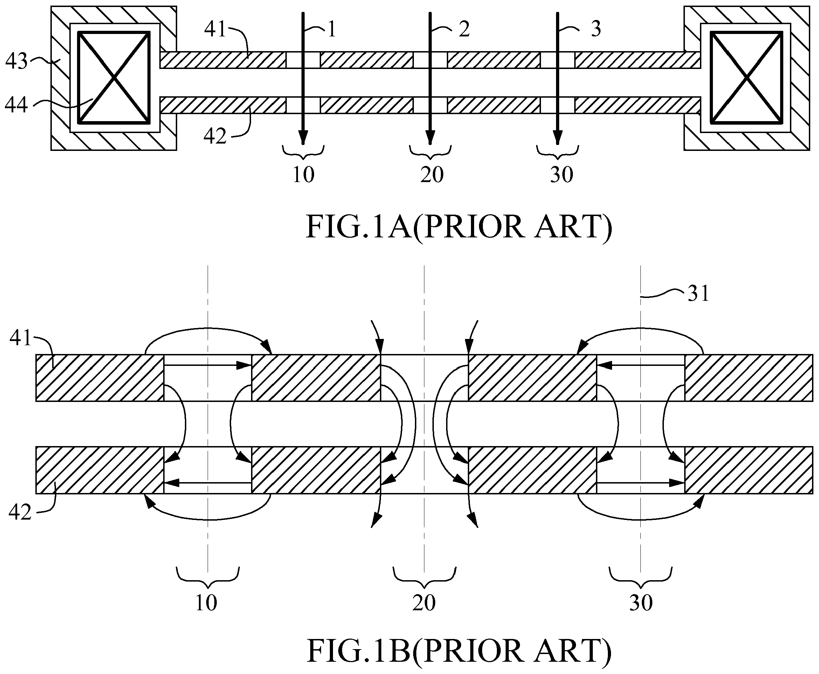

The first patent using a multi-axis magnetic lens to separately focus several parallel electron beams was granted to Maekawa et al. in 1973 for throughput improvement of an IC pattern exposure system. The multi-axis magnetic lens includes one common excitation coil 44, one yoke 43, and two magnetic conductor plates 41 and 42 with a plurality of through holes for the corresponding charged particle beams (1, 2 and 3) passing through, which was proposed in US 3,715,580 and was illustrated in Figure 1A. Between a pair of aligned holes in the upper and lower magnetic conductor plate 41 and 42, a sub-lens or sub-lens module such as 10 is formed, so as sub-lenses 20 and 30. The two magnetic conductor plates 41 and 42 are the pole pieces of these sub-lenses 10, 20 and 30. In this multi-axis magnetic lens, the magnetic fields of the sub-lenses are fundamentally different from each other in distribution pattern and strength as shown in Figure 1B.

Comparing with a conventional single-axis magnetic lens, one main problem of this multi-axis magnetic lens is the magnetic field distribution of each sub-lens degenerates from axial symmetry to rotation symmetry and/or n-fold symmetry (Figure 1B). As a result, besides an axisymmetric field or called as round lens field which focuses a particle beam, a lot of undesired non-axisymmetric transverse field components or called as high order harmonics in terms of Fourier analysis of a magnetic field, such as dipole field and quadrupole field appear. The dipole field deflects the charged particle beam, makes the beam land on the imaging plane with an additional transverse shift, an additional tilt angle and additional aberrations. The quadrupole field adds astigmatism to the beam. To compensate the influence of each high order harmonic, at least one additional element generating the same type field is required to add to the electron optics system.

Another main problem of this multi-axis magnetic lens is the round lens field of the center sub-lens 20 is a little different from those of the peripheral sub-lenses 10 and 30. This problem results in that the charged particle beams 2, 1 and 3 respectively passing through the center sub-lens 20 and the peripheral sub-lenses 10 and 30 are not focused at the same imaging plane.

Many scientists who followed Maekawa's foot steps have tried many methods to solve these two main problems. For example, US 6750455 of Lo et al. reduces the dipole field itself by using a plurality of dummy holes to improve the local structure symmetry of each sub-lens. US 6777694 of Haraguchi compensates the dipole field influence by inserting a deflector group in each sub-lens hole. By varying the thicknesses of some areas of one of the two magnetic conductor plate, DE 30 10 814 of Anger Klaus et al. eliminates the round lens field differences among all the sub-lenses. US 6703624 of Hamaguchi et al. and US 2001/0028046 of Hamaguchi et al. insert a pair of magnetic insert rings in each pair of aligned holes, which accordingly function as a pair of magnetic pole pieces of the sub-lens. In these two documents, the round lens field differences among all the sub-lenses are eliminated by changing the diameters of the two pole pieces or the gap size between the two pole pieces in each sub-lens to control the magnetic flux leakage. US 6703624 of Hamaguchi et al. and US 7253417 of Frosien et al. compensate the round lens field differences by inserting an auxiliary round coil or an electrostatic lens in each sub-lens.

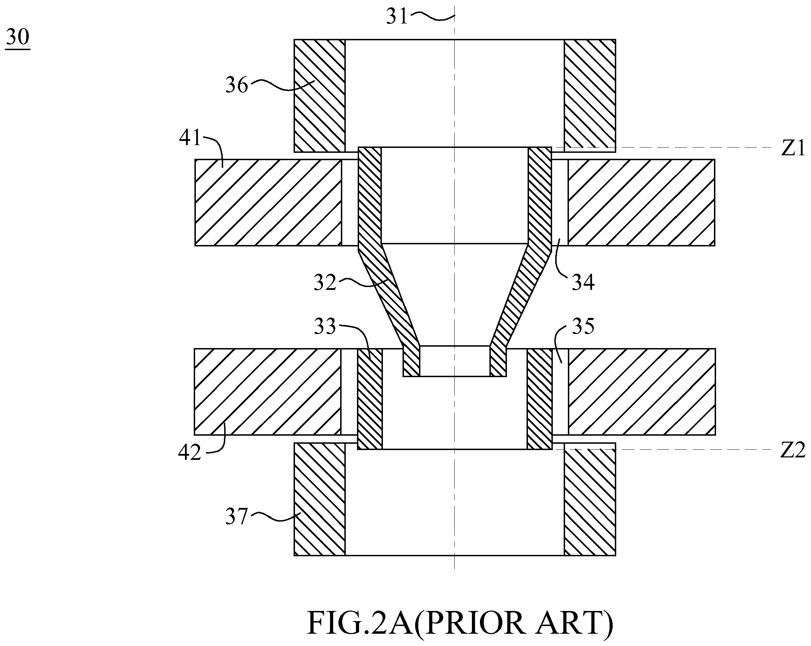

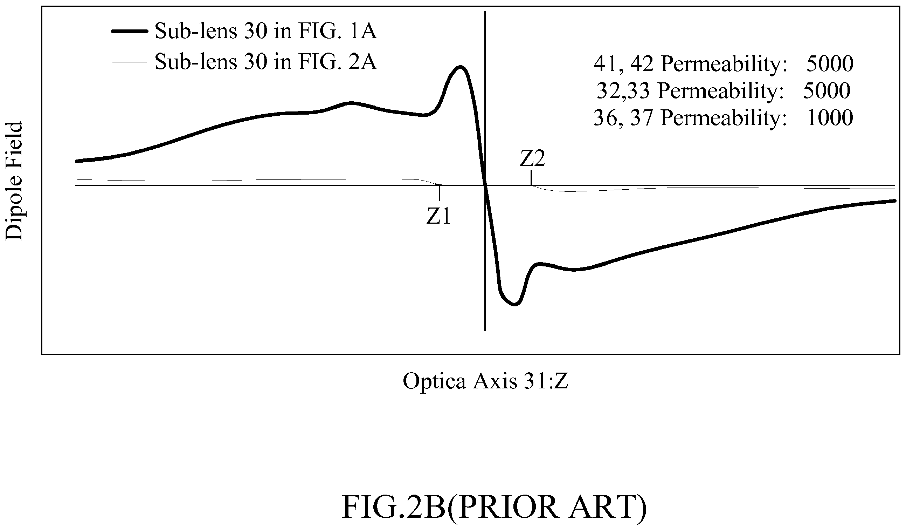

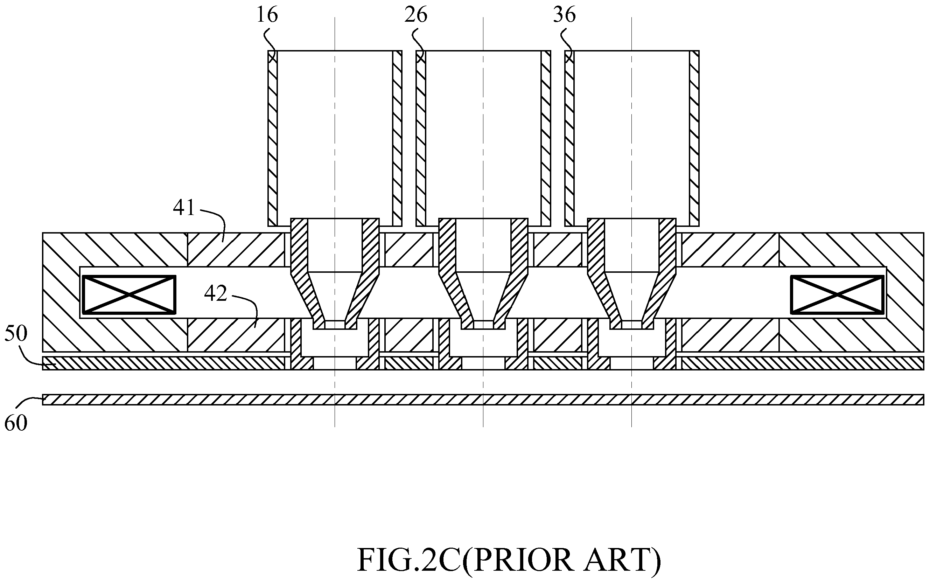

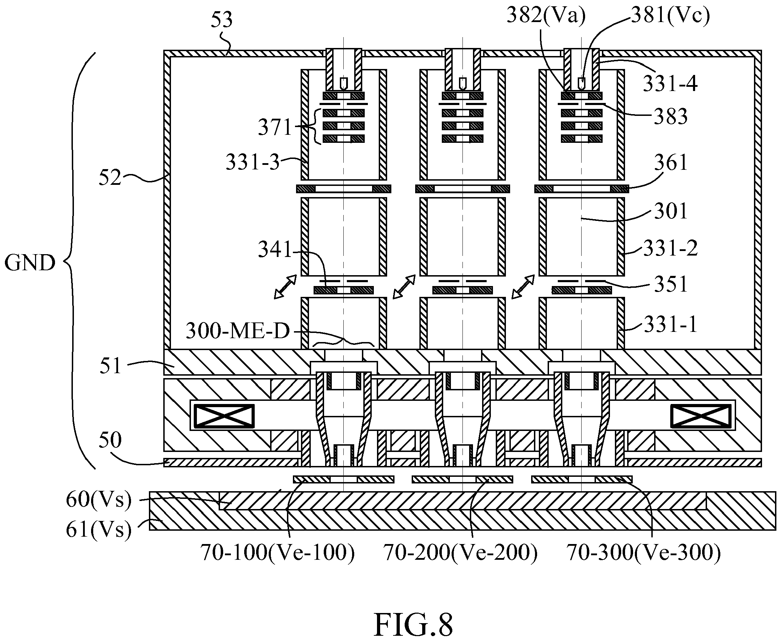

These previous methods were either making the magnetic conductor plate larger, the multi-axis magnetic lens system bulky, or making it complicated, and could only compensate the influences of high order harmonics partially. Chen et al. filed U.S. Patent Application No. 12/636,007 entitled "Multi-axis magnetic lens" (now US 8,003,953) in December 2009 to provide a better solution. The corresponding European patent application EP2510523 A is prior art under Article 54(3) EPC. Its main principle is shown in Figure 2A (corresponding to Fig. 8A of EP2510523 A) by taking the sub-lens 30 in FigurelA as an example. In the sub-lens 30, two magnetic rings 32 and 33 are respectively inserted into the paired holes in the upper and lower magnetic plates 41 and 42, wherein the upper magnetic ring 32 and the lower magnetic ring 33 are respectively called as an upper pole-piece and a lower pole-piece. A portion of the bottom end of the upper pole-piece 32 extends inside a portion of the top end of the lower pole-piece 33. Both of the upper pole-piece 32 and the lower pole-piece 33 are made of a magnetic material with a high permeability, and do not touch the inner sidewall of the correspondent hole. The upper and lower spatial gaps 34 and 35 can respectively be either a vacuum space or filled with a non-magnetic material. A space magnetic field along the optical axis 31 is generated through the space gap (functioning as a magnetic circuit gap) between the upper pole-piece 32 and the lower pole-piece 33. In Figure 2A, the non-axisymmetric transverse field components almost become zero in the area inside the upper pole-piece 32 and the lower pole-piece 33, and are reduced by two magnetic tubes 36 and 37 to a level much lower than in Figure 1A in the areas above the upper pole-piece 32 and below the lower pole-piece 33 respectively. As an example the dipole field reduction is shown in Figure 2B. The round lens field differences among all of the magnetic sub-lenses can be eliminated by appropriately choosing each non-magnetic gap (34 and 35) size. In this patent application, Chen et al. also provides an embodiment of multi-axis magnetic objective lens, as shown in Fig. 2C (corresponding to Fig.11 of EP2510523 A), wherein each sub-lens generates a magnetic field confined within the axial magnetic circuit gap between its upper and lower pole-pieces.

Nevertheless, it is well known that, compared with a radial-gap magnetic lens (having a radial magnetic circuit gap), this type magnetic lens generates larger aberrations which damages spatial resolution, but requires small coil excitation (product of coil turns and coil current) which abates the issue of system overheat. In addition, a magnetic shielding plate 50 with a plurality of circular openings is used to replace all of the individual magnetic tubes between the specimen 60 and the lower magnetic conductor plate 42.

The present invention will adopt the main principle of Chen's multi-axis magnetic lens and further improve its performance as a multi-axis magnetic immersion objective lens, so as to provide a multi-axis charged particle apparatus which uses a plurality of charged particle beams to inspect a specimen in parallel with a high spatial resolution and a high throughput.

### SUMMARY OF THE INVENTION

The object of this invention is to provide a multi-axis charged particle apparatus employing a multi-axis magnetic lens and LVSEM (low-voltage scanning electron microscope) technology, which uses a plurality of low-energy charged particle beams to inspect a specimen in parallel. In this apparatus, by specifically constructing a multi-axis magnetic immersion objective lens and overlapping it with an electron deceleration, a multi-axis electromagnetic compound immersion objective lens is formed to generate lower aberrations and lower radiation damage on a specimen. Hence, this invention can provide a higher spatial resolution and a higher throughput than the prior arts mentioned above, which can especially benefit the wafer or mask defect inspection in semiconductor yield management. The descriptions below will focus on using a plurality of electron beams, and, however, it would be recognized that the invention has a much broader range of applicability.

Accordingly, this invention provides a multi-axis magnetic immersion objective lens for focusing a plurality of charged particle beams onto a specimen ; as defined in claim 1. Similar to the multi-axis magnetic lens Chen et al. proposed, the multi-axis magnetic immersion objective lens comprises a common excitation coil and a plurality of magnetic sub-lens modules. The plurality of magnetic sub-lens modules is formed by a pair of parallel magnetic conductor plates with a plurality of through round holes in pairs therein, a plurality of magnetic rings in pairs inside and aligned with the plurality of through round holes with a plurality of first radial gaps in pairs respectively. The common excitation coil is between the pair of the magnetic conductor plates for providing a magnetic flux to the plurality of magnetic sub-lens modules. The pair of parallel magnetic conductor plates includes an upper magnetic conductor plate and a lower magnetic conductor plate, wherein for each paired through round holes, an upper through round hole in the upper magnetic conductor plate is aligned with a lower through round hole in the lower magnetic conductor plate. For each pair of magnetic rings in each paired through round holes, an upper magnetic ring inside the upper through round hole is aligned with and extends downward inside a lower magnetic ring inside the lower through round hole. Each paired first radial gaps are formed by each paired through round holes and the corresponding paired magnetic rings, and include a first upper radial gap between an inner sidewall of the upper through round hole and an outer sidewall of the upper magnetic ring, and a first lower radial gap between an inner sidewall of the lower through round hole and an outer sidewall of the lower magnetic ring. Therefore each magnetic sub-lens module is formed by one paired through round holes, one paired magnetic rings therein and one paired first radial gaps therebetween. For each magnetic sub-lens module, the upper and lower magnetic rings function as a pair of magnetic pole-pieces.

Different from the prior art, there are two improvements in this multi-axis magnetic immersion objective lens. At first, in each magnetic sub-lens module, the upper and lower magnetic rings form a second radial gap between bottom ends thereof, wherein the bottom end of the upper magnetic ring extends downward through the bottom end of the lower magnetic ring. The second radial gap has a size larger than sizes of the paired first radial gaps and is vacuum or filled with a non-magnetic material, thereby functioning as a magnetic circuit gap. As a result, each magnetic sub-lens has a radial magnetic circuit gap and the upper and lower magnetic rings function as an inner pole-piece and an outer pole-piece respectively. The specimen will be located below the lower magnetic conductor plate. In this case, when an excitation current flows through the common excitation coil, through the radial magnetic circuit gap of each magnetic sub-lens module, a magnetic round lens field will be generated to immerse the specimen. Due to the magnetic field immersion to the specimen, each magnetic sub-lens module therefore becomes a magnetic immersion sub-lens module which can focus an electron beam with lower aberrations. It is well known that the stronger the immersion is, the smaller the aberrations will be.

Secondly, to reduce magnetic non-axisymmetric transverse field components in areas respectively above and below the pair of magnetic conductor plates, the multi-axis magnetic immersion objective lens further comprises an upper magnetic shielding plate and a lower magnetic shielding plate. The upper magnetic shielding plate is above the upper magnetic conductor plate with an upper axial gap and has a plurality of upper circular openings, while the lower magnetic shielding plate is under the lower magnetic conductor plate with a lower axial gap and has a plurality of lower circular openings. The plurality of upper circular openings is aligned with the plurality of upper through round holes respectively and the plurality of lower circular openings is aligned with the plurality of lower through round holes respectively. The upper and lower axial gaps are respectively vacuum or filled with a non-magnetic material. Hence for the plurality of magnetic sub-lens modules, the additional aberrations due to the magnetic non-axisymmetric transverse field components will decrease very much.

Each paired first radial gaps can be vacuum or filled with a non-magnetic material. Each upper circular opening may have a shape of upside-down counterbore. A top end of each inner pole-piece can extend upward inside a lower portion of the upside-down counterbore without touching an inner wall thereof, and has an inner diameter equal to or larger than an inner diameter of an upper portion of the upside-down counterbore. Bottom ends of each pair of the inner and outer pole-pieces can extend downward inside the corresponding lower circular opening without touching an inner sidewall thereof and stop at or above a bottom surface of the lower magnetic shielding plate. For each magnetic sub-lens module, a bottom surface of the inner pole-piece may be at or below a bottom surface of the outer pole-piece. The specimen can be sustained by a magnetic stage. The magnetic stage can magnetically couple with the inner and outer pole-pieces of each magnetic sub-lens module so as to enhance the magnetic field immersion to the specimen.

For the plurality of magnetic sub-lens modules, the second radial gaps can be unequal to each other. In this case the plurality of first radial gaps may have equal sizes. The second radial gaps can be identical to each other, and the plurality of first radial gaps may have sizes increasing with a distance from each first radial gap to a geometric central axis of the pair of parallel magnetic conductor plates. For the plurality of through round holes, the holes located on the central portion of the pair of parallel magnetic conductor plates may have inner diameters smaller than those located on the peripheral portion of the pair of parallel magnetic conductor plates. For the plurality of inner and outer pole-pieces, the pole-pieces located on the central portion of the pair of parallel magnetic conductor plates may have outer diameters larger than those located on the peripheral portion of the pair of parallel magnetic conductor plates. For each pair of magnetic rings, the upper magnetic ring can have a cylindrical shape or funnel shape with a narrow bottom end inside the lower magnetic ring.

This invention also provides a multi-axis electromagnetic compound immersion objective lens for focusing a plurality of charged particle beams onto a specimen, which comprises one multi-axis magnetic immersion objective lens mentioned above, and a flat electrode. The flat electrode is located below the lower magnetic shielding plate and has a plurality of circular orifices respectively aligned with the plurality of inner pole-pieces. The specimen will be located below the flat electrode. A plurality of electrostatic sub-lens modules is therefore formed in combination with the specimen, and is respectively aligned and paired with the plurality of magnetic sub-lens modules. For each paired magnetic sub-lens module and electrostatic sub-lens module, the electrostatic sub-lens module comprises the inner pole-piece, a rim of the circular orifice in the flat electrode and the specimen as a first electrode, a second electrode, and a third electrode respectively.

In comparison with the prior art, the improvements of the multi-axis magnetic immersion objective lens improve the multi-axis electromagnetic compound immersion objective lens. At first, each magnetic sub-lens module has one radial magnetic circuit gap formed by the paired of magnetic rings and close to the specimen. Hence each magnetic sub-lens module will generate a strong magnetic field immersion to the specimen when the excitation current flows through the common excitation coil, thereby reducing the conventional aberrations (due to a round lens field) of the paired magnetic sub-lens module and electrostatic sub-lens module. Secondly, the upper and lower magnetic shielding plates sandwich the pair of parallel magnetic conductor plates. Hence the magnetic non-axisymmetric transverse field components will be obviously reduced in areas respectively above and below the plurality of magnetic sub-lens modules when the excitation current flows through the common excitation coil, and thereby simultaneously decreasing the additional aberrations (due to non-axisymmetric transverse field components) of all of the magnetic sub-lens modules.

In the multi-axis electromagnetic compound immersion objective lens, each first radial gap can be vacuum or filled with a non-magnetic material. Bottom ends of each pair of the inner and outer pole-pieces can extend downward inside the corresponding lower circular opening without touching the inner sidewall thereof and stop at or above a bottom surface of the lower magnetic shielding plate. A bottom surface of the inner pole-piece may be at or below a bottom surface of the outer pole-piece.

For the plurality of magnetic sub-lens modules, the second radial gaps can be identical to each other. In this case, the plurality of first radial gaps may have sizes increasing with a distance from each first radial gap to a geometric central axis of the pair of parallel magnetic conductor plates. For the plurality of through round holes, the holes located on the central portion of the pair of parallel magnetic conductor plates may have inner diameters smaller than those located on the peripheral portion of the pair of parallel magnetic conductor plates. For the plurality of inner and outer pole-pieces, the pole-pieces located on the central portion of the pair of parallel magnetic conductor plates may have outer diameters larger than those located on the peripheral portion of the pair of parallel magnetic conductor plates. For each pair of magnetic rings, the upper magnetic ring may have a cylindrical shape or funnel shape with a narrow bottom end inside the lower magnetic ring. The flat electrode can be divided into a plurality of individual segments, and each segment includes one of the plurality of circular orifices in the flat electrode.

This invention further provides a multi-axis charged particle apparatus for observing a specimen by a plurality of charged particle beams, which comprises a multi-axis electromagnetic compound immersion objective lens, a plurality of deflection scanning and compensation units respectively located inside a plurality of magnetic sub-lens models in the multi-axis electromagnetic compound immersion objective lens, a plurality of sub-columns located over the multi-axis electromagnetic compound immersion objective lens, a magnetic shielding house enclosing the plurality of sub-columns and a specimen stage below the multi-axis electromagnetic compound immersion objective lens.

The multi-axis electromagnetic compound immersion objective lens comprises one multi-axis magnetic immersion objective lens mentioned above and a plurality of flat electrodes each located below the lower magnetic shielding plate and with a circular orifice. The circular orifices in the plurality of flat electrodes are respectively aligned with the plurality of lower circular openings. A plurality of electrostatic sub-lens modules is therefore formed in combination with the specimen, and is respectively aligned and paired with the plurality of magnetic sub-lens modules. For each paired magnetic sub-lens module and electrostatic sub-lens module, the electrostatic sub-lens module comprises the inner pole-piece, the corresponding flat electrode and the specimen as a first electrode, a second electrode, and a third electrode respectively. In comparison with the prior art, the improvements of the multi-axis magnetic immersion objective lens as mentioned above improve the multi-axis charged particle apparatus. At first, each magnetic sub-lens module has one radial magnetic circuit gap formed by the paired of magnetic rings and close to the specimen. Hence each magnetic sub-lens module will generate a strong magnetic field immersion to the specimen when the excitation current flows through the common excitation coil, thereby reducing the conventional aberrations (due to a round lens field) of the charged particle beam passing through. Secondly, the upper and lower magnetic shielding plates sandwich the pair of parallel magnetic conductor plates. Hence the magnetic non-axisymmetric transverse field components will be obviously reduced in areas respectively above and below the plurality of magnetic sub-lens modules when the excitation current flows through the common excitation coil, and thereby simultaneously decreasing the additional aberrations (due to non-axisymmetric transverse field components) of the plurality of the charged particle beams passing through respectively.

Each of the plurality of deflection scanning and compensation unit comprises an upper electrostatic multi-pole lens located at a top end of and aligned with the inner pole-piece and generating a dipole field only, or a dipole field and a quadrupole field, and an lower electrostatic multi-pole lens located at a bottom end of and aligned with the inner pole-piece and generating a dipole field only or a dipole field and a quadrupole field. A deflection scanning unit is therefore formed to scan one of the plurality of charged particle beams on the specimen, and a compensation unit is formed to compensate the influence of the dipole field and the quadrupole field generated by the corresponding magnetic sub-lens module.

The plurality of sub-columns is respectively aligned with the plurality of magnetic sub-lens modules. Each sub-column comprises a charged particle source for generating one of the plurality of charged particle beams, a condenser below the charged particle source for condensing the charged particle beam, a beam limit aperture below the condenser for confining the charged particle beam, a detector below the beam limit aperture for collecting a signal charged particle beam emanated from the specimen, a first magnetic shielding tube enclosing a first space between the detector and the upper magnetic shielding plate and aligned with the corresponding upper circular opening, wherein a lower end of the first magnetic shielding tube stacks on a top surface of the upper magnetic shielding plate, a second magnetic shielding tube enclosing a second space between the condenser and the beam limit aperture, a third magnetic shielding tube enclosing the charged particle source and the condenser, a fourth magnetic shielding tube enclosing the charged particle source inside the third magnetic shielding tube. The magnetic shielding house encloses the plurality of sub-columns. Each sub-column may further comprise a fifth magnetic tube between the detector and the beam limit aperture. In comparison with the prior art, the magnetic shielding tubes in each sub-column and the magnetic shielding house improve the performance of the multi-axis charged particle apparatus. At first, the magnetic shielding tubes in each sub-column further reduce the magnetic non-axisymmetric transverse field components in the area from the charged particle source to the upper magnetic shielding plate. Then the magnetic shielding house effectively reduces the magnetic non-axisymmetric transverse field components leaked onto each charge particle path through the gaps among the magnetic shielding tubes of each sub-column.

The pair of parallel magnetic conductor plates, the plurality of magnetic rings, the upper magnetic shielding plate, the lower magnetic shielding plate, each first magnetic shielding tube, each second magnetic shielding tube, each third magnetic shielding tube, each fourth magnetic shielding tube, and the magnetic shielding house can be set at ground potential. Each charged particle source can be an electron source at a first negative potential. The specimen and the specimen stage can be set at a second negative potential higher than the first negative potential of each electron source. Each flat electrode can be set at a third potential equal to or higher than the second negative potential of the specimen. On the one hand, the plurality of flat electrodes can be set at same potentials, and can be united to be a single large flat electrode which includes all of the circular orifices of the plurality of flat electrodes. On the other hand, the plurality of flat electrodes can be set at different potentials.

Each first radial gap can be vacuum or filled with a non-magnetic material. For each magnetic sub-lens module, the first upper and lower radial gaps may have equal sizes. The specimen stage can be made of a magnetic material and therefore magnetically couple with the inner and outer pole-pieces of each magnetic sub-lens to enhance the magnetic field immersion to the specimen.

Each upper circular opening may have a shape of upside-down counterbore. A top end of each inner pole-piece can extend upward inside a lower portion of the upside-down counterbore without touching an inner wall thereof, and have an inner diameter equal to or larger than an inner diameter of an upper portion of the upside-down counterbore. Bottom ends of each pair of the inner and outer pole-pieces can extend downward inside the corresponding lower circular opening without touching an inner sidewall thereof and stop at or above a bottom surface of the lower magnetic shielding plate. In each magnetic sub-lens module, a bottom surface of the inner pole-piece can be at or below a bottom surface of the outer pole-piece.

For the plurality of magnetic sub-lens modules, the second radial gaps can be identical to each other. In this case the first upper and lower radial gaps of the sub-lens modules located on a central portion of the pair of parallel magnetic conductor plates may have sizes smaller than those located on a peripheral portion of the pair of parallel magnetic conductor plates. For the plurality of through round holes, the holes located on the central portion of the pair of parallel magnetic conductor plates may have inner diameters smaller than those located on the peripheral portion of the pair of parallel magnetic conductor plates. For the plurality of inner and outer pole-pieces, the pole-pieces located on the central portion of the pair of parallel magnetic conductor plates may have outer diameters larger than those located on the peripheral portion of the pair of parallel magnetic conductor plates. For each pair of magnetic rings, the upper magnetic ring may have a cylindrical shape or funnel shape whose narrow bottom end is inside the lower magnetic ring.

### BRIEF DESCRIPTION OF THE DRAWINGS

The present invention will be readily understood by the following detailed description in conjunction with the accompanying drawings, wherein like reference numerals designate like structural elements, and in which:
Figure 1A is a schematic illustration of a conventional multi-axis magnetic lens.
Figure 1B is a schematic illustration of magnetic flux lines in Figure 1A.
Figure 2A is a schematic illustration of a sub-lens in a modified conventional multi-axis magnetic lens.
Figure 2B is a schematic illustration of on-axis dipole field distribution of a sub-lens in Figure 1A and Figure 2A.
Figure 2C is a schematic illustration of an example of the modified conventional multi-axis magnetic lens in Figure 2A as a magnetic objective lens.
Figure 3A to Figure 3D are schematic illustrations of variant magnetic sub-lenses in a multi-axis magnetic immersion objective lens in accordance with a first embodiment of the present invention.
Figure 4 is a schematic illustration of an electromagnetic compound sub-lens in a multi-axis electromagnetic compound immersion objective lens in accordance with a second embodiment of the present invention.
Figure 5 is a schematic illustration of an electromagnetic compound sub-lens and a deflection scanning and compensation unit in a multi-axis electromagnetic compound immersion objective lens in accordance with a third embodiment of the present invention.
Figure 6A and Figure 6B are schematic top illustrations of three magnetic sub-lenses with different gap sizes in a multi-axis electromagnetic compound immersion objective lens in accordance with another embodiment of the present invention.
Figure 7 is a schematic illustration of a multi-axis charged particle apparatus in accordance with another embodiment of the present invention.
Figure 8 is a schematic illustration of a multi-axis charged particle apparatus in accordance with another embodiment of the present invention.

### DETAILED DESCRIPTION OF THE INVENTION

Reference will now be made in detail to specific embodiments of the invention. Examples of these embodiments are illustrated in accompanying drawings. While the invention will be described in conjunction with these specific embodiments, it will be understood that it is not intended to limit the invention to these embodiments. On the contrary, the scope of the invention is defined by the appended claims. In the following description, numerous specific details are set forth in order to provide a through understanding of the present invention. The present invention may be practiced without some of these specific details. In other instances, well known process operations are not described in detail in order not to unnecessarily obscure the present invention.

In this invention, all terms relate to through round holes, circular openings, or circular orifices mean round openings or circular holes penetrated through one plate. Sometimes, especially through round holes always refer to holes in a magnetic conductor plate, circular openings always refer to holes in a magnetic shielding plate, and circular orifices always refer to holes in an electrode plate. Further, the term of "radial gap" means two circular articles are concentric in which the radial gap is between the two circular articles.

The present invention provides an apparatus employing a multi-axis magnetic lens and LVSEM (low-voltage scanning electron microscope) technology, that uses a plurality of low-energy charged particle beams to inspect a specimen in parallel. In this apparatus, by specifically constructing a multi-axis magnetic immersion objective lens and overlapping it with a charged particle deceleration, a multi-axis electromagnetic compound immersion objective is formed to generate lower aberrations and lower radiation damage on specimen. Hence, this invention can provide a higher spatial resolution and a higher throughput than the previous patents mentioned above, which can especially benefit the wafer or mask defect inspection in semiconductor yield management. The descriptions below will focus on using a plurality of electron beams, which are a kind of charged particles. However, it would be recognized that the invention has a much broader range of applicability. For example, a plurality of electron beams can be applied to E-beam inspection tool, or E-beam lithography, while charge particle other than electrons, such as ion beams, can be applied to FIB (Focused Ion Beam).

The multi-axis magnetic immersion objective lens provided in this invention comprises a pair of parallel magnetic conductor plates with a plurality of through round holes in pairs therein, a plurality of magnetic rings in pairs inside and aligned with the plurality of through round holes with a plurality of first radial gaps in pairs respectively, and a common excitation coil between the pair of the magnetic conductor plates for providing a magnetic flux to the plurality of magnetic rings. The plurality of through round holes in pairs means one through round hole in one plate of the pair of magnetic conductor plates=corresponds to the other through round hole in the other plate of the pair of magnetic conductor plates. The plurality of magnetic rings in pairs means one magnetic ring in one through round hole in one plate of the pair of magnetic conductor plates corresponds to the other magnetic ring in the other through round hole in the other plate of the pair of magnetic conductor plates.

The pair of magnetic conductor plates includes an upper magnetic conductor plate and a lower magnetic conductor plate, wherein for each paired through round holes, an upper through round hole in the upper magnetic conductor plate is aligned with the corresponding lower through round hole in the lower magnetic conductor plate.

For each pair of magnetic rings, an upper magnetic ring in the upper through round hole is aligned with and extends downward through the inside of the corresponding lower magnetic ring in the lower through round hole with a second radial gap formed between bottom ends thereof. Each paired first radial gaps include a first upper radial gap between the inner sidewall of the upper through round hole and the outer sidewall of the upper magnetic ring, and a first lower radial gap between the inner sidewall of the lower through round hole and the outer sidewall of the lower magnetic ring. For each magnetic sub-lens module, sizes of the first upper and lower radial gaps are smaller than the size of the second radial gap. The first upper and lower radial gaps can have equal size or unequal sizes. The first radial gaps and second radial gaps can be vacuum or filled with a non-magnetic material. For the plurality of magnetic sub-lens modules, the second radial gaps can be unequal to each other or identical with each other.

The plurality of magnetic sub-lens modules is therefore formed for focusing a plurality of charged particle beams respectively, wherein for each magnetic sub-lens module, the upper magnetic ring functions as an inner pole-piece, the lower magnetic ring functions as an outer pole-piece and the second radial gap functions as a magnetic circuit gap. Therefore each magnetic sub-lens module can generate a magnetic round lens field which immerses a specimen. The inner pole-piece may have a cylindrical shape or funnel shape with its narrow bottom end inside the outer pole-piece.

The multi-axis magnetic immersion objective lens further comprises a yoke to enclose the common excitation coil and to connect to the pair of magnetic conductor plates.

The multi-axis magnetic immersion objective lens can adapt to a magnetic stage sustaining the specimen thereon, wherein the magnetic stage is under the lower magnetic conductor plate. The magnetic stage will magnetically couple with the inner pole-piece and out pole-piece of each magnetic sub-lens module to enhance the magnetic field immersion to the specimen.

The multi-axis magnetic immersion objective lens further comprises an upper magnetic shielding plate located over the upper magnetic conductor plate and having a plurality of upper circular openings, and a lower magnetic shielding plate located under the lower magnetic conductor plate and having a plurality of lower circular openings. Both of the plurality of upper circular openings and the plurality of lower circular openings are aligned with the plurality of through round holes respectively. For each magnetic sub-lens module, the top end of the inner pole-piece can extend upward to the inside of the upper circular opening with a third upper radial gap whose size can be equal to the size of the first upper radial gap, and stop at or below the top surface of the upper magnetic shielding plate. Each upper circular opening can have an upside-down counterbore, and the top end of the inner pole-piece can extend upward inside the lower portion of the upside-down counterbore without touching inner wall thereof, in which the inner diameter of the inner pole-piece is equal to or larger than that of the upper portion of the upside-down counterbore. For each magnetic sub-lens module, bottom ends of the inner pole-piece and outer pole-piece can extend downward inside the lower circular opening with a third lower radial gap whose size can be equal to the size of the first lower radial gap, and stop at or above the bottom surface of the lower magnetic shielding plate.

For each magnetic sub-lens module, a first working distance is defined between the bottom end of the inner pole-piece and the specimen surface, and a second working distance is defined between the bottom end of the outer pole-piece and the specimen surface. The first working distance and the second working distance can be equal or unequal. In a preferred embodiment, the first working distance is shorter than the second working distance.

For the plurality of magnetic sub-lens modules, the plurality of first radial gaps can have sizes increasing with a distance from each first radial gap to a geometric central axis of the pair of magnetic conductor plates. Accordingly, the through round holes located on the central portion of the pair of parallel magnetic conductor plates can have inner diameters smaller than those located on the peripheral portion of the pair of parallel magnetic conductor plates.

The following will describe some embodiments of the multi-axis magnetic immersion objective lens in this invention with referring to drawings. Although all the discussions are based on a structure of one magnetic sub-lens for one electron beam, however, it would be recognized the present invention can be applied to a plurality of magnetic sub-lenses and has a much broader range of applicability. Although the number of magnetic sub-lens is free to increase, it is better to locate the new magnetic sub-lens with the least increasing of the geometric structure's asymmetry of the multi-axis magnetic immersion objective lens.

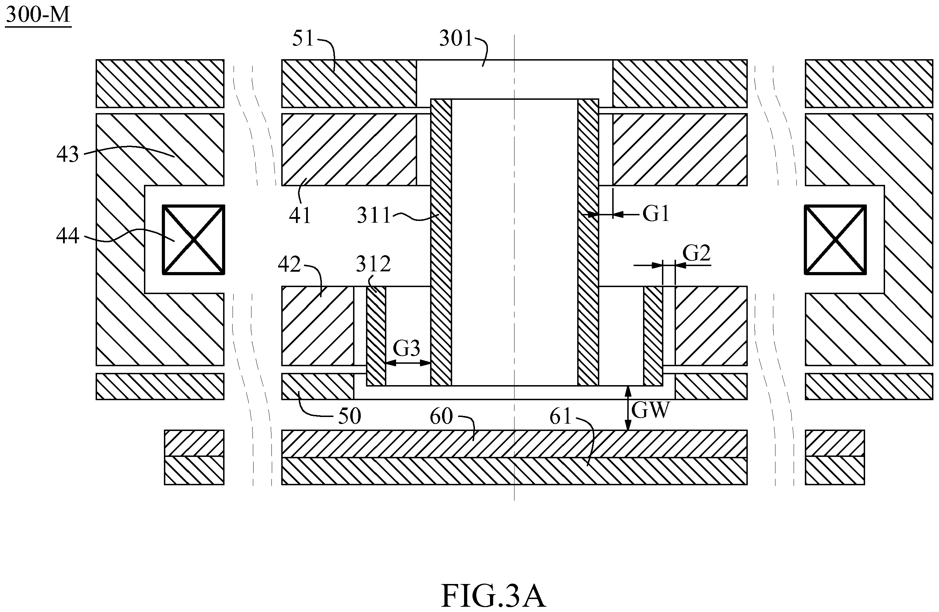

The multi-axis magnetic immersion objective lens in each of Figure 3A~Figure 3D comprises one common excitation coil 44, two magnetic conductor plates 41 and 42, and a plurality of magnetic ring in pairs (311 plus 312). To explain it clearly, only one sub-lens named as 300-M is shown. The upper magnetic conductor plate 41 and the lower magnetic conductor plate 42 have a plurality of through round holes in pairs respectively, wherein for each paired through round holes, the upper through round hole in the upper magnetic conductor plate 41 is aligned with the corresponding lower through round hole in the lower magnetic conductor plate 42. Although the size of the upper through round hole in Figure 3A~Figure 3D is smaller than the size of the lower through round hole, both the upper and lower through round holes can be the same in size. In a preferred embodiment, the lower through round hole has a larger size compared to the upper through round hole.

The plurality of magnetic rings in pairs is configured in the plurality of through round holes respectively. For each paired magnetic rings, the upper magnetic ring 311 and the lower ring 312 are configured in the upper through round hole and lower through round hole with the first upper radial gap G1 and the first lower radial gap G2 respectively. Both the upper magnetic ring 311 and the lower magnetic ring 312, which are made of a material with high permeability and aligned with each other, are cylindrical in one embodiment as shown in Figure 3A. At the bottom ends of the upper magnetic ring 311 and the lower magnetic ring 312, the second radial gap G3 is formed. The first radial gaps G1 and G2 and the second radial gap G3 are vacuum or filled with a non-magnetic material. The sizes of the first radial gaps G1 and G2 are smaller than the size of the second radial gap G3. A magnetic sub-lens module is therefore formed by the upper and lower through round holes, the first radial gaps G1 and G2, the second radial gap G3 and the two magnetic rings 311 and 312. The upper magnetic ring 311 functions as an inner pole-piece, the lower magnetic ring 312 functions as an outer pole-piece, and the second radial gap G3 functions as a magnetic circuit gap. The excitation coil 44 provides a magnetic flux to flow through the inner pole-piece 311 and the outer pole-piece 312 and leak out through the magnetic circuit gap G3. The thicknesses of the first radial gaps G1 and G2 are chosen by taking account of the residual of the non-axisymmetric transverse field components and the coil excitation. The thinner the first radial gaps are, the stronger the non-axisymmetric transverse field components will be left. The thicker the first radial gaps are, the higher the excitation of the coil 44 will be required.

The multi-axis magnetic immersion objective lens further comprises a coil yoke 43, and two magnetic shielding plates 50 and 51. The coil yoke 43 and the two magnetic conductor plates 41 and 42 cover the coil 44 from side, top and bottom respectively. The two magnetic shielding plates 51 and 50 are respectively located above the upper magnetic conductor plate 41 with an upper axial gap and under the lower magnetic conductor plate 42 with a lower axial gap. The specimen stage 61 is located under the lower magnetic shielding plate 50 and supports the specimen 60. There is a plurality of lower circular openings in the lower magnetic shielding plate 50 and a plurality of upper circular openings in the upper magnetic shielding plate 51 for electron beams passing through respectively. Each through round hole or circular opening in one of these four plates 41, 42, 50 and 51 is aligned with three other holes and openings respectively in the remaining three plates.

The inner pole-piece 311 extends through and is aligned with the upper and lower through round holes. In addition, its top end can further extend upward inside the lower part of the upper circular opening with the third upper radial gap as shown in Figure 3A, and its bottom end further extends downward inside the lower circular opening. The outer pole-piece 312 extends through the lower through round hole from the outside of the inner pole-piece 311. Its bottom end can further extend inside the lower circular opening with the third lower radial gap. The third upper and lower radial gaps are either vacuum or filled with a non-magnetic material.

The length of axial space gap GW or the first working distance between the inner pole-piece 311 and the surface of the specimen 60 is equal to the second working distance between the outer pole-piece 312 and the surface of the specimen 60 in Figure 3A. If the common excitation coil 44 is excited by a current, a magnetic round lens field is provided through the radial magnetic circuit gap G3 between each pair of the inner and outer pole-pieces 311 and 312. Hence, it is said that each pair of inner and outer pole-pieces 311 and 312 forms a radial-gap magnetic sub-lens, and in this invention a plurality of such magnetic sub-lenses can be formed although in Figure 3A only one such magnetic sub-lens is shown. As conventionally, the first working distance is called as working distance of a magnetic sub-lens. The plurality of such magnetic sub-lenses are excited by the common excitation coil 44.

One magnetic sub-lens will be used to focus an electron beam to a probe spot on the specimen surface 60 for specimen inspection. Due to the second radial gap G3 between the inner pole-piece 311 and the outer pole-piece 312, the magnetic sub-lens can provide a very strong magnetic field immersion on the specimen surface, and hence the probe spot has small aberrations.

The specimen stage 61 in Fig. 3A is magnetic. Compared with conventionally using a non-magnetic specimen stage, using a magnetic specimen stage can further enhance the magnetic round lens field of each magnetic sub-lens and move the magnetic field peak thereof closer to the specimen. Consequently, at first, the common coil excitation (the excitation of the common excitation coil 44) required to focus each electron beam is reduced, which solves the conventional concern that a radial-gap magnetic lens needs a larger coil excitation. Therefore, an extra cooling device for removing exhausting heat is not necessary even when using a short working distance which usually requires a larger coil excitation. This design avoids additionally increasing complexity and instability of the system. Secondly, a short working distance can be used without increasing much coil excitation. Using a short working distance reduces the focal length of a magnetic sub-lens and shortens the operation range of the residual non-axisymmetric transverse magnetic field components in front of the specimen. As a result, it reduces the basic axisymmetric aberrations (spherical and chromatic aberrations) and the additional non-axisymmetric aberrations at the same time. Thirdly, the magnetic field immersion on the specimen is increased because the magnetic field peak is closer to the specimen. It is well known that the stronger the immersion is, the smaller the aberrations will be.

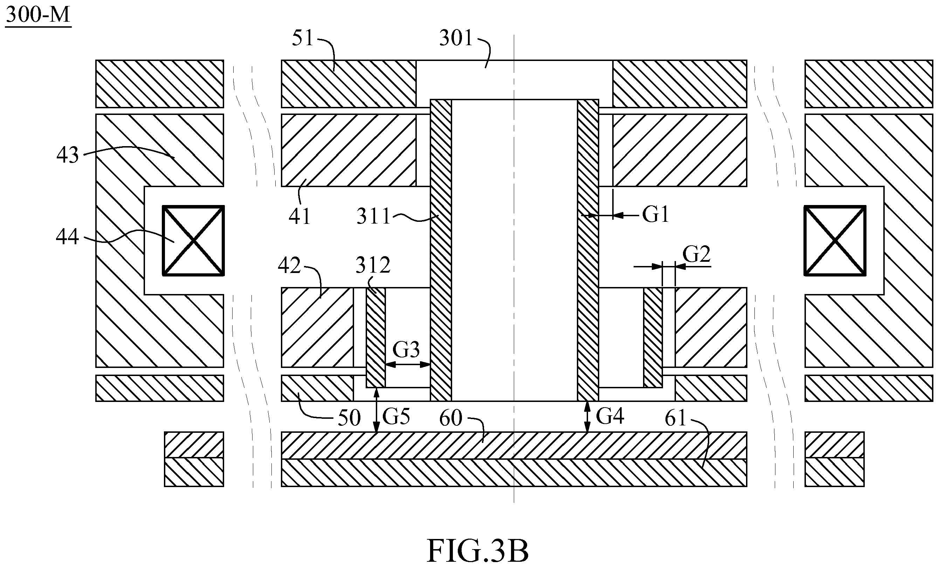

Please refer to Figure 3B, in which another embodiment of the multi-axis magnetic immersion objective lens is provided. In this embodiment, the first working distance G4 between the surface of the specimen 60 and the bottom end of the inner pole-piece 311 is shorter than the second working distance G5 between the surface of the specimen 60 and the bottom end of the outer pole-piece 312. In this configuration, the magnetic field provided by the inner pole-piece 311 can further enhance magnetic field immersion on the specimen 60.

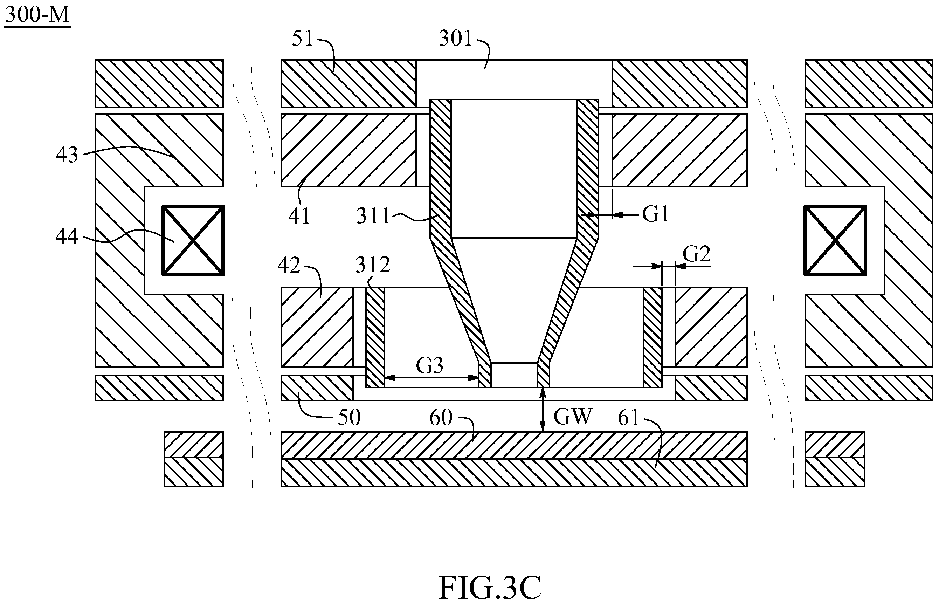

Please refer to Figure 3C, in which still another embodiment of the multi-axis magnetic immersion objective lens is provided. In this embodiment, the inner pole-piece 311 has a funnel outline that can reduce the magnetic coupling between the inner pole-piece 311 and the outer pole-piece 312, and make more magnetic flux leak out though the radial magnetic circuit gap G3 at the bottom ends of the inner pole-piece 311 and the outer pole-piece 312. This makes this embodiment need a coil excitation smaller than the previous two embodiments.

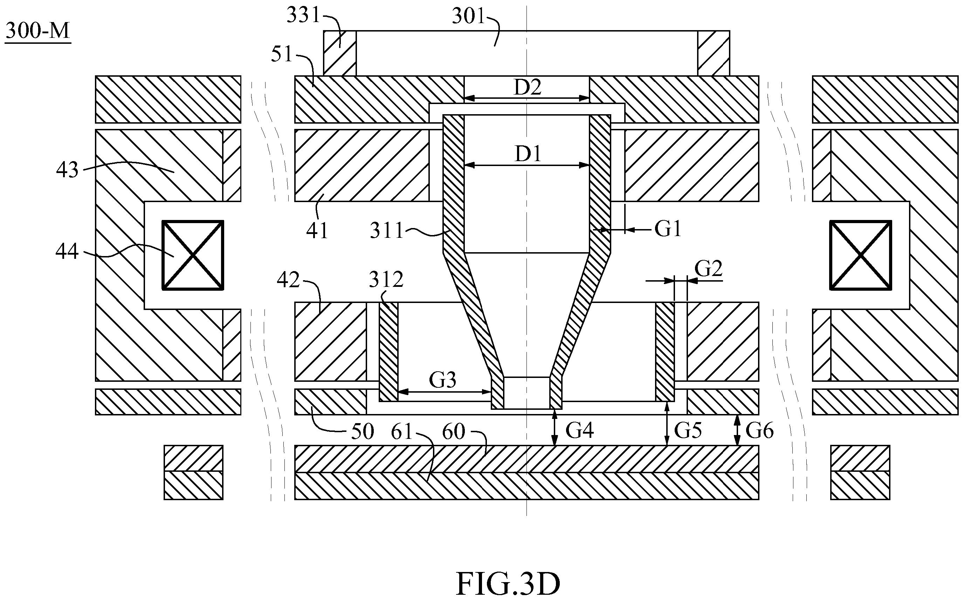

Figure 3D shows a preferred embodiment of the multi-axis magnetic immersion objective lens The top end of the inner pole-piece 311 extends inside the lower part of the upper through round hole with a upside-down counterbore shape, and has an inner diameter D1 nearly equal to the inner diameter D2 of the upper part of that hole.

Both of the second working distance G5 and the first working distance G4 are longer than the axial gap G6 between specimen 60 and lower shielding magnetic plate 50 in Figure 3D. The first and second working distances G4 and G5 are not necessarily to have same lengths, and the first working distance G4 is preferred shorter than the second working distance G5. It depends on the required orientation of the magnetic circuit gap G3. When G4 is a little shorter than G5, the gap G3 is turned to face away from the optical axis 301 and a deeper magnetic immersion to the specimen 60 is provided. This strong magnetic field immersion reduces the aberrations of sub-lens 300-M to a great degree. The magnetic immersion can be further enhanced when the stage 61 is made of a magnetic material. Although the multi-axis magnetic immersion objective lens has a non-axisymmetric structure, each sub-lens within it is axisymmetrical about the sub-lens optical axis.

In this embodiment, the upper portion of the upside-down couterbore with the diameter D2 smaller than the outer diameter of the inner pole-piece 311 can shield the magnetic field leaked out from the top end thereof. Further, the magnetic tube 331 is stacked on the magnetic shielding plate 51 to shield the magnetic flux leaked out from the portions of the magnetic shielding plate 51 outside this sub-lens module.

To realize a low radiation damage on a specimen, the electron beam must land on the specimen surface with a low energy. It is well known that the lower the electron beam energy is, the stronger the Coulomb effect will be. To reduce the Coulomb effect as much as possible, electron deceleration or called as retarding is employed. The electron beam is initially accelerated to a high kinetic energy and subsequently decelerated to a desired low final landing energy just prior to impinging onto the specimen. This is realized by combining a multi-axis electrostatic immersion objective lens with the multi-axis magnetic immersion objective lens mentioned above. The multi-axis electrostatic immersion objective lens includes a plurality of electrostatic sub-lenses and each is therefore formed in combination with the specimen. Each electrostatic sub-lens is overlapped and paired with each magnetic sub-lens in the multi-axis magnetic immersion objective lens, so as to provide an electrostatic retarding field to decelerate the electron beam passing through.

In each pair of electrostatic sub-lens and magnetic sub-lens, the electrostatic sub-lens is formed by the inner pole-piece of the magnetic sub-lens, the specimen and a flat electrode located between the specimen and the inner pole-piece. The flat electrode can be an individual plate with a circular orifice aligned with the inner pole-piece, or a single plate with a plurality of circular orifices, wherein each circular orifice is aligned with each inner pole-piece. In an electrostatic sub-lens, the inner pole-piece is set at ground potential, the specimen is set at a negative potential Vs, and the flat electrode plate is set at a potential Ve equal to or higher than Vs. The retarding field generated by each electrostatic sub-lens can provide an effective way to reduce Coulomb effect and imaging aberrations at the same time. For example, after being emitted from a cathode at a negative potential Vc which is lower than the specimen potential Vs, the electrons can be accelerated to a higher energy |e.Vc| immediately, then keep this energy when passing through the following system, and finally be decelerated by the retarding field to a desired low landing energy |e·(Vs-Vc)| just prior to impinging onto the specimen.

The retarding field includes at least a negative electrostatic lens field. The negative aberrations generated by a negative electrostatic lens (divergent lens) can compensate most of the positive aberrations generated by a magnetic sub-lens. The combination of the multi-axis magnetic immersion objective lens and the multi-axis electrostatic immersion objective lens is called as multi-axis electromagnetic compound immersion objective lens, and the combination of a pair of magnetic sub-lens and electrostatic sub-lens is called as an electromagnetic compound immersion objective sub-lens.

This invention then provides a multi-axis electromagnetic compound immersion objective lens, which comprises the multi-axis magnetic immersion objective lens proposed in this invention and a flat electrode with a plurality of circular orifices. Each circular orifice is aligned with the inner pole-piece of each magnetic sub-lens. A plurality of electrostatic sub-lens modules is therefore formed in combination with a specimen and respectively aligned and paired with the plurality of magnetic sub-lens modules, wherein each electrostatic sub-lens module includes the inner pole-piece, the flat electrode and the specimen as a first electrode, a second electrode, and a third electrode respectively. The flat electrode can be divided into a plurality of individual segments, and each segment includes one of the plurality of circular orifices in the flat electrode..

The following will describe an embodiment of the multi-axis electromagnetic compound immersion objective lens in this invention with referring to drawings. Although all the discussions are based on a structure of one electromagnetic compound sub-lens for one electron beam, however, it would be recognized the present invention can be applied to a plurality of electromagnetic compound sub-lenses and has a much broader range of applicability. Although the number of electromagnetic compound sub-lens is free to increase, it is better to locate the new electromagnetic compound sub-lens with the least increasing of the geometric structure's asymmetry of the multi-axis magnetic immersion objective lens.

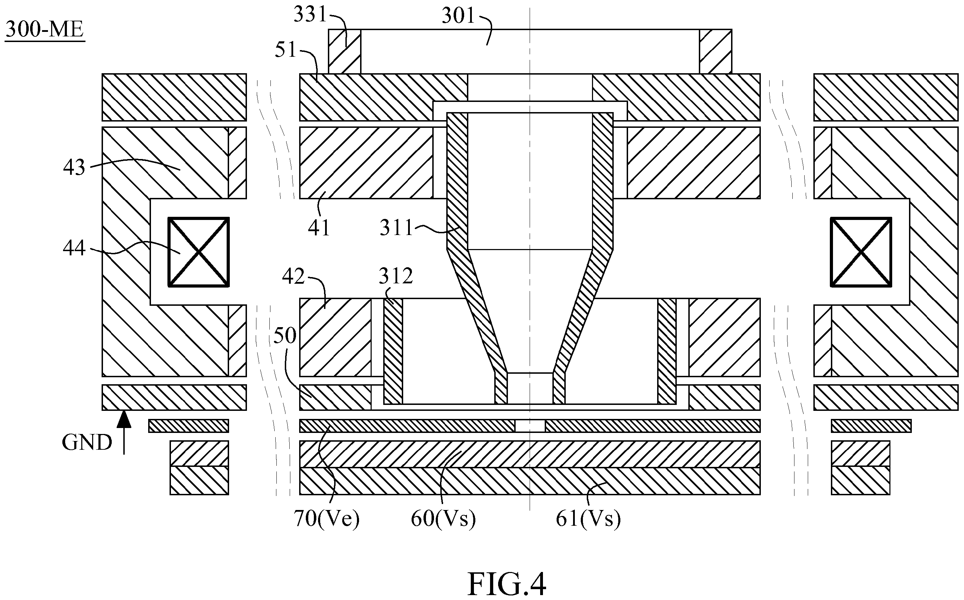

Figure 4 shows a structure of an embodiment of the multi-axis electromagnetic compound immersion objective lens according to the present invention. To explain it clearly, only one electromagnetic compound sub-lens named as 300-ME is shown. A flat electrode 70 with a circular orifice is inserted between the specimen 60, the lower shielding plate 50 and the inner pole-piece 311, wherein the inner diameter of the circular orifice is equal to or little different from the inner diameter of the inner pole-piece 311. All of the magnetic elements (41, 42, 50, 51, 311, 312, 331) are set at ground potential. The specimen 60 and the magnetic stage 61 are set at a negative potential Vs, and the flat electrode 70 is set at a potential Ve equal to or higher than Vs. In this way a retarding field is generated in front of the specimen 60, and an electron beam can be decelerated just prior to impinging onto the specimen 60. The retarding method reduces the radiation damage on the specimen without obviously increasing Coulomb effect. The retarding field includes at least one negative electrostatic lens field. The negative aberrations generated by the negative electrostatic lens (divergent lens) can compensate most of the positive aberrations generated by pure magnetic sub-lens 300-M. Hence, the aberration coefficients of the electromagnetic compound sub-lens 300-ME are reduced to be 10∼20% of those of the pure magnetic sub-lens 300-M.

To realize scanning a plurality of electron beams on the specimen in parallel, a plurality of deflection scanning units can be added to the multi-axis electromagnetic compound immersion objective lens mentioned above. Each deflection scanning unit is inserted inside the inner pole-piece in each electromagnetic compound immersion objective sub-lens. Each deflection scanning unit includes two deflectors, respectively located at the top and bottom ends of the inner-pole-piece. Both operate as a group to realize a close-to-lens-field deflection (or called as swing deflection) scanning which generates smaller off-axis aberrations. If the effect of the residual magnetic dipole fields at the two ends of the inner pole-piece is obviously degrade the quality of the electron beam landing on the specimen, these two deflectors can additionally be used to cancel the effect. In addition, if the effect of the residual magnetic quadrupole fields at the two ends of the inner pole-piece is obviously degrade the quality of the electron beam landing on the specimen, these two deflectors can be constructed having a multi-pole structure so as to be able to operate as deflector and stigmator at the same time, wherein these two stigmators can be used to cancel the effect. In these two cases mentioned above, a deflection scanning unit can be generally renamed as deflection scanning and compensation unit.

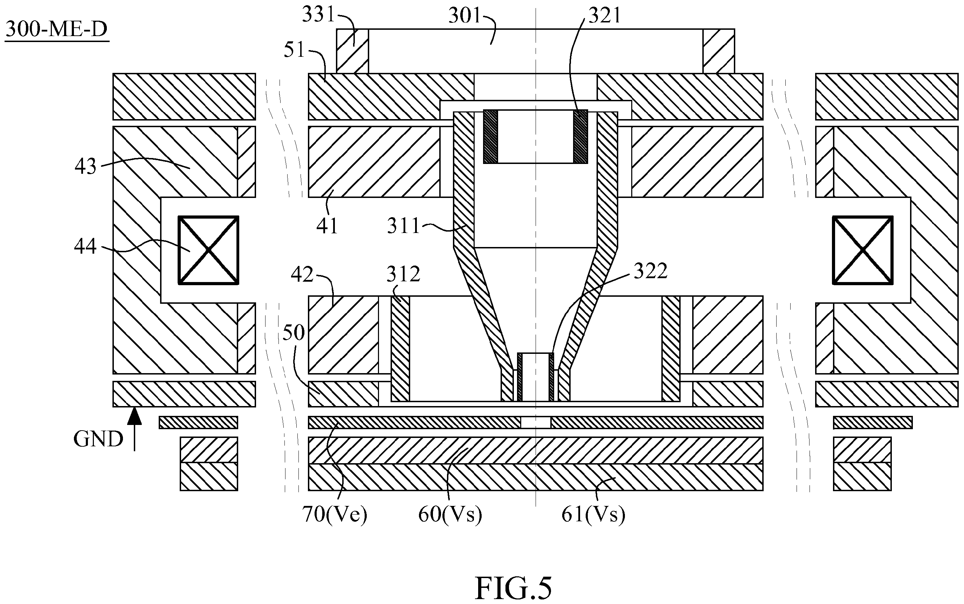

Figure 5 shows a structure of an embodiment of the multi-axis electromagnetic compound immersion objective lens with a plurality of deflection scanning units according to the present invention. To explain it clearly, only one combination 300-ME-D of one electromagnetic compound sub-lens 300-ME and one deflection scanning unit is shown. A pair of electrostatic deflectors 321 and 322 is inserted inside the bore of the inner pole-piece 311. The No.1 deflector 321 is located near the top end of 311, and the No.2 deflector 322 is located near the bottom end of 311. The two deflectors 321 and 322 operate together as a deflection scanning unit to scan the electron beam passing through the 300-ME on the surface of the specimen 60. Because the deflection field generated by No.2 deflector 322 is very close to the magnetic round lens field of the sub-lens 300-ME, the deflection scanning generates smaller off-axis aberrations. This makes it possible to use a large field of view when inspecting the specimen 60. Moreover, the two deflectors 321 and 322 can also be used to directly compensate the influence of the residual magnetic dipole field at the two ends of the inner pole-piece 311. The deflectors 321 and 322 can also be designed to have a multi-pole structure which can work as a quadrupole lens as well as a dipole lens. In this case, the deflectors 321 and 322 can also be used to directly compensate the influence of the residual magnetic quadrupole fields at the two ends of the inner pole-piece 311. Because the compensation happens where the residual magnetic dipole and/or quadrupole field exists, the compensation effect will be very effective.

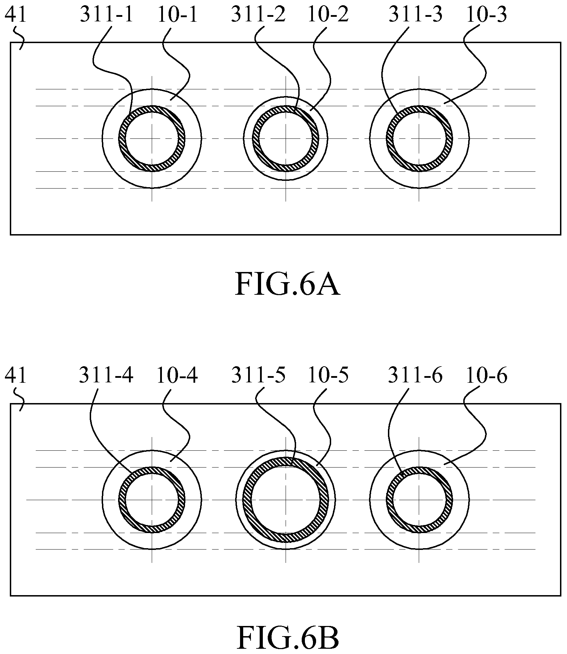

Figure 6A and Figure 6B illustrate the first radial gaps may vary among different sub-lens modules. Although all the first radial gaps can be identical, a preferred embodiment is the first radial gap in the central sub-lens would be thinner than the first radial gaps in the peripheral sub-lens modules. To achieve this purpose, one way is that the central through round hole 10-2 in the upper magnetic conductor plate 41, as shown in Figure 6A, can be shrunk directly compared to the neighbor through round holes 10-1 and 10-3. It is noted that the central magnetic ring 311-2 has the same size compared to other peripheral magnetic rings 311-1 and 311-3. Another way is to enlarge the central magnetic ring 311-5, as shown in Figure 6B, while the peripheral magnetic rings 311-4 and 311-6 keep the same sizes. It is noted that all the through round holes 10-4, 10-5, and 10-6 are identical in the upper magnetic conductor plate 41 in Figure 6B. However, there is still some other ways to shrink the central through round hole and enlarge the central magnetic ring simultaneously and keep the peripheral through round holes as well as the peripheral magnetic rings constant.

Further, a multi-axis charged particle apparatus of using a plurality of electron beams to inspect a specimen in parallel can be constructed by using the multi-axis electromagnetic compound immersion objective lens and a plurality of close-to-lens-field deflection scanning units mentioned above. Each electromagnetic compound immersion objective sub-lens in the multi-axis electromagnetic compound immersion objective lens is combined with a close-to-lens-field deflection scanning unit, and the combination is called as a focusing and scanning sub-unit.

On the top area of each focusing and scanning sub-unit, from top to bottom, there is an individual electron gun, an individual electrostatic condenser, a beam limit aperture and a detector. An electron beam is generated by the electron gun and weakly focused by the condenser. The beam limit aperture confines the current of the electron beam by cutting off the electrons with larger polar angles. The detector has a center through round hole, so that the electron beam can pass through and enter the following focusing and scanning sub-unit. The focusing and scanning sub-unit focuses the electron beam to be a low-voltage probe spot on the specimen surface and scans it. Secondary electrons are emitted from the incident site of the probe spot on specimen surface, then pass through the focusing and scanning sub-unit and finally most of them land on the detector.

To reduce the non-axisymmetric transverse magnetic field components in the path of each electron beam as much as possible, the space from each electron gun to the top end of each magnetic sub-lens is magnetically shielded by four individual magnetic tubes. Counting from bottom to top, the first magnetic tube is stacked on the upper magnetic shielding plate of the multi-axis magnetic objective lens to shield the space from the top end of the magnetic sub-lens to the detector. The second magnetic tube is located above the first magnetic tube with an axial space gap to shield the space from the beam limit aperture to the vacuum gate valve which separates the gun and the column. The space gap is designed for installing and replacing the detector and beam limit aperture when operating routine maintenance. The third magnetic tube is located above the second magnetic tube with an axial space gap to shield the space from the gun to the vacuum gate valve. The space gap is designed for installing the vacuum gate valve. The fourth magnetic tube is located to overlap with the top end of the third magnetic tube from inside, which is especially designed to fully cover the gun tip. A small deviation of an electron trajectory generated by the residual dipole field in the area near the gun tip will be magnified by the following system to a big landing position deviation on the specimen surface. To eliminate the non-axisymmetric transverse magnetic field components in all of the space gaps between the adjacent magnetic tubes, all of the magnetic tubes are covered by a magnetic shielding house formed by a larger common magnetic tube and a larger magnetic shielding plate on the top of the apparatus.

This invention thus provides such a multi-axis charged particle apparatus, which comprises the multi-axis electromagnetic compound immersion objective lens, the plurality of deflection scanning and compensation units respectively located inside the plurality of magnetic sub-lens models in the multi-axis electromagnetic compound immersion objective lens, a plurality of sub-columns located over the multi-axis electromagnetic compound immersion objective lens, the magnetic shielding house enclosing the plurality of the sub-columns and a specimen stage below the multi-axis electromagnetic compound immersion objective lens. The specimen being inspected will be on the specimen stage.

The multi-axis electromagnetic compound immersion objective lens comprises the multi-axis magnetic immersion objective lens and either the plurality of flat electrodes (or segments) each with a circular orifice or the one flat electrode with all of the circular orifices of the plurality of flat electrodes.

Each of the plurality of deflection scanning and compensation units comprises an upper electrostatic multi-pole lens located at the upper end of and aligned with the inner pole-piece, and generating a dipole field only, or a dipole field as well as a quadrupole field, and an lower electrostatic multi-pole lens located at the lower end of and aligned with the inner pole-piece, and generating a dipole field only or a dipole field and a quadrupole field. Among each deflection scanning and compensation unit, the deflection scanning unit is therefore formed to scan one of the plurality of charged particle beams on the specimen, and the compensation unit is formed to compensate the influence of the dipole field and the quadrupole field generated by the multi-axis electromagnetic compound immersion objective lens.

Each of the plurality of sub-columns is aligned with each of the plurality of electromagnetic compound immersion objective sub-lenses, and comprises the individual electron gun, the individual electrostatic condenser, the beam limit aperture, the detector, the first magnetic shielding tube, the second magnetic shielding tube, the third magnetic shielding tube, and the fourth magnetic shielding tube. The magnetic shielding house encloses the plurality of sub-columns. Each sub-column may further comprise a fifth magnetic tube enclosing the space between the detector and the beam limit aperture.

The pair of parallel magnetic conductor plates, the plurality of magnetic rings, the upper magnetic shielding plate, the lower magnetic shielding plate, the first magnetic shielding tube, the second magnetic shielding tube, the third magnetic shielding tube, the fourth magnetic shielding tube, and the magnetic shielding house are set at ground potential.

Each electron source is at a negative potential. The specimen is set at a negative potential higher than the potential of each electron source. The plurality of flat electrodes can be set at either same potentials, or different potentials all equal to or higher than the potential of the specimen.

The following will describe some embodiments of the multi-axis charged particle apparatus in this invention with referring to drawings. Although all the discussions are based on a structure of three electromagnetic compound sub-lenses for three electron beams, however, it would be recognized the present invention can be applied to more than three electromagnetic compound sub-lenses and has a much broader range of applicability. Although the number of electromagnetic compound sub-lens is free to increase, it is better to locate the new electromagnetic compound sub-lens with the least increasing of the geometric structure's asymmetry of the multi-axis magnetic immersion objective lens.

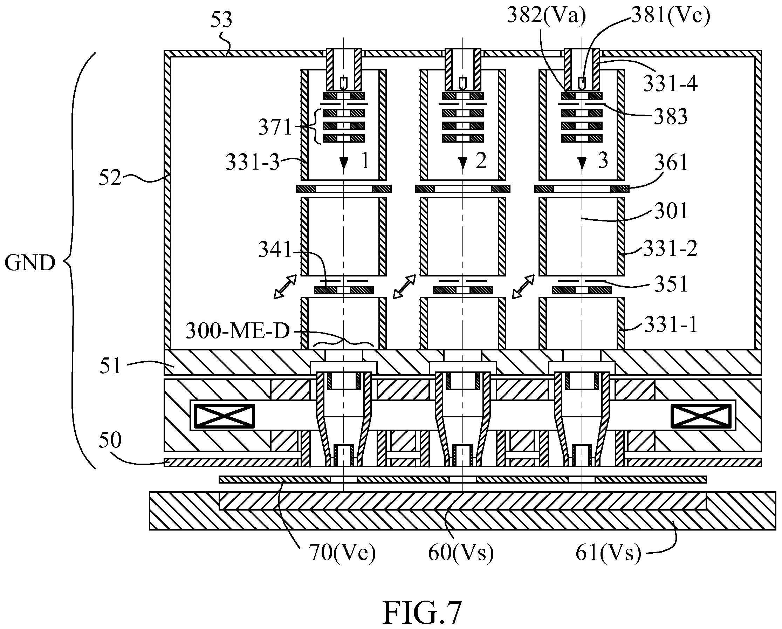

Figure 7 shows an embodiment of the multi-axis charged particle apparatus. The same elements in the apparatus are named by same numbers except three electron beams. Three electron beams 1∼3 are emitted respectively by three individual cathodes (381). Beam 3 is taken as an example to describe the structure. When cathode 381 is at a negative potential Vc and the anode 382 is at a specific potential Va higher than Vc, the electron beam 3 is emitted. The gun aperture 383 is at ground potential, and cuts the current of the electron beam 3 to be just larger then the maximum probe current for inspecting specimen. The electrostatic condenser 371 weakly focuses the beam 3 and control the current of the beam 3 passing through the beam limit aperture 351. The beam 3 passes through the center hole of the detector 341, and then enters into the focusing and scanning sub-unit 300-ME-D.

The specimen 60 and the specimen stage 61 are at a negative potential Vs which is higher than the potential Vc of the cathode 381. Vs is set to ensure the landing energy |e·(Vs-Vc)| of the beam 3 to be a low energy such as <5keV. The flat electrode 70 is at a potential Ve which is equal to or higher than Vs. The potential difference Ve-Vs is set to control the electrostatic field over the entire surface of the specimen 60 to be weaker than a permissible value for the specimen safety. The focusing and scanning sub-unit 300-ME-D focuses, scans and decelerates the beam 3 onto the surface of the specimen 60. The spot of the beam 3 on the surface of the specimen 60 is called as probe spot. Secondary electrons are emitted from the incident site of the probe spot 3 on specimen surface, then pass through the focusing and scanning sub-unit 300-ME-D and finally most of them land on the detector 341.

To reduce the non-axisymmetric transverse magnetic field components in the path of beam 3 from the cathode 381 to the upper magnetic shielding plate 51, four magnetic tubes 331-1 ~ 331-4 are located along the path. The first magnetic tube 331-1 is stacked on the upper magnetic shielding plate 51. The space between the first magnetic tube 331-1 and second magnetic tube 331-2 is designed for installing and replacing the detector 341 and beam limit aperture 351 during routine preventive maintenance process. The space between the second magnetic tube 331-2 and third magnetic tube 331-3 is designed for installing the vacuum gate valve 361. The fourth magnetic tube 331-4 is especially designed to fully cover the cathode 381. A small electron trajectory deviation generated by the residual dipole field in the area near the electron gun will be magnified by the following condenser and objective sub-lens, and finally adds larger additional aberrations to the size and position of the probe spot on the surface of the specimen 60. To eliminate the non-axisymmetric transverse magnetic field components in the space gaps between the magnetic tubes 331-1∼331-4, all of the magnetic tubes are covered by the magnetic shielding house formed by the larger magnetic tube 52 and the top magnetic plate 53.

The flat electrode plate in the multi-axis electrostatic objective lens can be either a larger single plate with a plurality of circular orifices respectively aligned with the inner pole-pieces, or includes a plurality of small independent plate which has a center circular orifice aligned with one inner pole-piece.

Figure 8 shows another embodiment of the multi-axis charged particle apparatus. Different from the embodiment in Figure 7, the large flat electrode 70 is replaced by three small flat electrodes 70-100, 70-200 and 70-300. The potentials of these three electrodes, Ve-100, Ve-200 and Ve-300 can be adjusted independently to compensate the fine focusing power difference among the three electromagnetic compound sub-lenses.

In this invention, at first a multi-axis magnetic immersion objective lens is provided, which comprises a plurality of magnetic sub-lenses each with a radial magnetic circuit gap facing a specimen surface which can be sustained by a magnetic specimen stage. This design not only makes each magnetic sub-lens focus a charged particle beam with lower aberrations, but also substantially reduces the common coil excitation so that the coil heat cooling is not necessary. Using a heat cooling unit will additionally increase complexity and instability of the objective lens. Secondly, a multi-axis electromagnetic compound immersion objective lens is provided, which comprises one multi-axis magnetic immersion objective lens mentioned above and a multi-axis electrostatic immersion objective lens which includes a plurality of electrostatic sub-lenses. Each electrostatic sub-lens generates a retarding field which makes it possible to realize inspecting the specimen with lower radiation damage and higher resolution at the same time. Thirdly, a plurality of deflection scanning and compensation units located inside one multi-axis electromagnetic compound immersion objective lens mentioned above is provided. Each deflection scanning and compensation unit acts as two deflectors and two stigmators at the same time to scan a focused particle beam on the specimen surface with lower off-axis aberrations and compensates the effect of the residual non-axisymmetric transverse field components in the magnetic sub-lens. Finally, a multi-axis charged particle apparatus using a plurality of charged particle beams to inspect the specimen in parallel is provided, which employs one multi-axis electromagnetic compound immersion objective and a plurality of deflection scanning and compensation units all mentioned above, a plurality of individual charged particle sources and a plurality of magnetic shielding units which wholly eliminate the non-axisymmetric transverse magnetic field components in the space from each charged particle source to the top end of the multi-axis electromagnetic compound immersion objective lens. Including all of the advantages mentioned above, the apparatus can consequently provide a higher spatial resolution and a higher throughput when inspecting a specimen, which can especially benefit the wafer or mask defect inspection in semiconductor yield management.

Although the present invention has been described in accordance with the embodiments shown, one of ordinary skill in the art will readily recognize that there could be variations to the embodiments limited only by the appended claims.

## Claims

1. A multi-axis magnetic immersion objective lens for focusing a plurality of charged particle beams onto a specimen (60), comprising a plurality of magnetic sub-lens modules (300-M;300-ME) formed by a pair of parallel magnetic conductor plates (41,42) and a common excitation coil (44) located between the pair of parallel magnetic conductor plates for providing magnetic flux to the plurality of magnetic sub-lens modules, the the pair of parallel magnetic conductor plates comprising a plurality of through round holes in pairs therein and a plurality of magnetic rings (311,312) in pairs inside and aligned with said plurality of through round holes in pairs respectively, wherein for each paired through round holes, an upper through round hole in an upper magnetic conductor plate (51) of said pair of parallel magnetic conductor plates is aligned with a lower through round hole in a lower magnetic conductor plate (50) of said pair of parallel magnetic conductor plates, for each paired magnetic rings inside said each paired through round holes, an upper magnetic ring (311) inside said upper through round hole is aligned with and extended downward into a lower magnetic ring (312) inside said lower through round,
**characterised in that** in each of the magnetic conductor plates (41, 42), the magnetic rings are aligned with the plurality of holes with a plurality of first radial gaps (G1, G2), wherein for each paired first radial gaps formed by said each paired through round holes and said each paired magnetic rings, a first upper radial gap (G1) is between an inner sidewall of said upper through round hole and an outer sidewall of said upper magnetic ring (311) and a first lower radial gap (G2) is between an inner sidewall of said lower through round hole and an outer sidewall of said lower magnetic ring (312), wherein each magnetic sub-lens module comprises said each paired through round holes, said each paired magnetic rings therein and said each paired first radial gaps therebetween, and said upper magnetic ring and said lower magnetic ring of said each paired magnetic rings function as an inner pole-piece and an outer pole-piece of said each magnetic sub-lens module, respectively,
further **characterised by** :
a second radial gap (G3) formed between bottom ends of said upper magnetic ring (311, with respect to 32) and said lower magnetic ring (312, with respect to 33) in said each magnetic sub-lens module, wherein said bottom end of said upper magnetic ring (311) extends downward through said lower magnetic ring (312), wherein said second radial gap (G3) has a size larger than sizes of said paired first radial gaps (G1 and G2, with respect to 34 and 35) and is vacuum or filled with a non-magnetic material,
an upper magnetic shielding plate (51) located above said upper magnetic conductor plate (41) with an upper axial gap therebetween and having a plurality of upper circular openings aligned with said plurality of through round holes respectively, wherein said upper axial gap is vacuum or filled with a non-magnetic material so that said upper magnetic shielding plate (51) will reduce magnetic non-axisymmetric transverse field components of said magnetic field generated by said each magnetic sub-lens module in an area above said upper magnetic conductor plate (41); and
a lower magnetic shielding plate (50) located below said lower magnetic conductor plate (42) with a lower axial gap therebetween and having a plurality of lower circular openings aligned with said plurality of through round holes respectively, wherein said lower axial gap is vacuum or filled with a non-magnetic material so that said lower magnetic shielding plate (50) will reduce said magnetic non-axisymmetric transverse field components of said magnetic field generated by said each magnetic sub-lens module in an area below said lower magnetic conductor plate (42).

2. A multi-axis electromagnetic compound immersion objective lens for focusing a plurality of charged particle beams onto a specimen, comprising:
a multi-axis magnetic immersion objective lens according to claim 1; and
a flat electrode (70) below said lower magnetic shielding plate (50) with a plurality of circular orifices, wherein said plurality of circular orifices are respectively aligned with said plurality of inner pole-pieces (311),
thereby forming a plurality of electrostatic sub-lens modules in combination with said specimen, wherein said plurality of electrostatic sub-lens modules is respectively aligned and paired with said plurality of magnetic sub-lens modules, wherein for each paired magnetic sub-lens module and electrostatic sub-lens module, said electrostatic sub-lens module comprises said inner pole-piece, said flat electrode and said specimen as a first electrode, a second electrode, and a third electrode respectively.

3. The multi-axis magnetic immersion objective lens according to claim 1, wherein each first radial gap is vacuum or filled with a non-magnetic material.

4. The multi-axis electromagnetic compound immersion objective lens according to claim 2, wherein each first radial gap is vacuum or filled with a non-magnetic material.

5. The multi-axis magnetic immersion objective lens according to claim 3, wherein each upper circular opening has a shape of upside-down counterbore, wherein for said each magnetic sub-lens module, a top end of said inner pole-piece (311) extends upward inside a lower portion of said each upside-down counterbore without touching an inner wall thereof, and has an inner diameter (D1) equal to or larger than an inner diameter (D2) of an upper portion of said upside- down counterbore, bottom ends of said inner and outer pole-pieces (311 and 312) extend downward inside said each lower circular opening without touching an inner sidewall thereof and stop at or above a bottom surface of said lower magnetic shielding plate (50).

6. The multi-axis magnetic immersion objective lens according to claim 5, further comprising a magnetic stage, wherein said magnetic stage magnetically couples with said inner and outer pole-pieces to enhance said magnetic field immersion to said specimen.

7. The multi-axis magnetic immersion objective lens according to claim 3, wherein for the plurality of magnetic sub-lens modules, said second radial gaps are unequal to each other.

8. The multi-axis magnetic immersion objective lens according to claim 3, wherein for said plurality of magnetic sub-lens modules, said second radial gaps are identical to each other, and said plurality of first radial gaps has sizes increasing with a distance from each first radial gap to a geometric central axis of the pair of parallel magnetic conductor plates,.

9. The multi-axis magnetic immersion objective lens according to claim 7, wherein said plurality of first radial gaps have equal sizes.

10. The multi-axis electromagnetic compound immersion objective lens according to claim 4, wherein for said each magnetic sub-lens module, bottom ends of said inner and outer pole-pieces extend downward inside said each lower circular opening without touching an inner wall thereof and stop at or above a bottom surface of said lower magnetic shielding plate (50), wherein for the plurality of magnetic sub-lens modules, said second radial gaps are identical to each other, and said plurality of first radial gaps has sizes increasing with a distance from each first radial gap to a geometric central axis of the pair of parallel magnetic conductor plates.

11. The multi-axis electromagnetic compound immersion objective lens according to claim 4, wherein for said each paired magnetic rings (311 and 312), said upper magnetic ring (311) has a cylindrical shape or funnel shape with a narrow bottom end inside said lower magnetic ring (312).

12. The multi-axis electromagnetic compound immersion objective lens according to claim 4, wherein said flat electrode is divided into a plurality of individual segments, and each segment includes one of said plurality of circular orifices in said flat electrode.

## Patentansprüche

1. Magnetische Immersionsobjektivlinse zum Fokussieren mehrerer elektrisch geladener Partikelstrahlen auf eine Probe (60), aufweisend mehrere magnetische Sub-Linsenmodule (300-M; 300-ME), die durch ein Paar parallele magnetische Leiterplatten (41,42) und eine gemeinsame Erregerspule (44) gebildet sind, die zwischen dem Paar parallele magnetische Leiterplatten angeordnet ist, um einen magnetischen Fluss für die mehreren magnetischen Sub-Linsenmodule vorzusehen, wobei das Paar parallele magnetische Leiterplatten mehrere darin paarweise ausgebildete Durchgangsrundlöcher und mehrere Magnetringe aufweist, die im Inneren paarweise ausgelegt und jeweils fluchtend mit den mehreren paarweise ausgebildeten Durchgangsrundlöchern ausgerichtet sind,
wobei für jedes der paarweise ausgebildeten Durchgangsrundlöcher ein oberes Durchgangsrundloch in einer oberen magnetischen Leiterplatte (51) des Paars parallele magnetische Leiterplatten mit einem unteren Durchgangsrundloch in einer unteren magnetischen Leiterplatte (50) des Paars parallele magnetische Leiterplatten fluchtet, für jeden paarweise ausgelegten Magnetring im Inneren jedes der paarweise ausgebildeten Durchgangsrundlöcher ein oberer Magnetring im Inneren des oberen Durchgangsrundlochs mit einen unteren Magnetring (312) des unteren Durchgangsrundloch fluchtet und sich in dessen Innerem abwärts erstreckt,
**dadurch gekennzeichnet, dass** in jeder der magnetischen Leiterplatten (41, 42) die Magnetringe mit den vielen Löcher mit mehreren ersten radialen Spalten (G1, G2) fluchtend ausgerichtet sind, wobei sich für sämtliche paarweise ausgelegte erste radiale Spalte, die durch jedes der paarweise ausgebildeten Durchgangsrundlöcher und jeden der paarweise ausgelegten Magnetringe gebildet sind, ein erster oberer radialer Spalt (G1) zwischen einer inneren Seitenwand des oberen Durchgangsrundlochs und einer äußeren Seitenwand des oberen Magnetrings (311) befindet, und sich ein erster unterer radialer Spalt (G2) zwischen einer inneren Seitenwand des unteren Durchgangsrundlochs und einer äußeren Seitenwand des unteren Magnetrings (312) befindet, wobei jedes magnetische Sub-Linsenmodul jedes der paarweise ausgebildeten Durchgangsrundlöcher, jeden der paarweise ausgelegten Magnetringe darin und jeden der paarweise ausgelegten ersten radialen Spalte dazwischen aufweist, und der obere Magnetring und der untere Magnetring jedes der paarweise ausgelegten Magnetringe als ein Innenpolstück bzw. ein Außenpolstück jedes magnetischen Sub-Linsenmoduls wirken,
ferner **gekennzeichnet durch**
einen zweiten radialen Spalt (G3), der zwischen unteren Enden des oberen Magnetrings (311, in Bezug auf 32) und des unteren Magnetrings (312, in Bezug auf 33) in jedem magnetischen Sub-Linsenmodul gebildet ist, wobei sich das untere Ende des oberen Magnetrings (311) **durch** den unteren Magnetring (312) hindurch abwärts erstreckt, wobei der zweite radiale Spalt (G3) eine Abmessung, die größer als Abmessungen der paarweise ausgelegten ersten radialen Spalte (G1 und G2, in Bezug auf 34 und 35) ist, aufweist und evakuiert ist oder mit einem nicht magnetischen Material gefüllt ist,
eine obere magnetische Abschirmungsplatte (51), die oberhalb der oberen magnetischen Leiterplatte (41) mit einem oberen axialen Spalt dazwischen angeordnet ist und mehrere obere runde Öffnungen aufweist, die jeweils mit den mehreren Durchgangsrundlöchern fluchtend ausgerichtet sind, wobei der obere axiale Spalt evakuiert ist oder mit einem nicht magnetischen Material gefüllt ist, so dass die obere magnetische Abschirmungsplatte (51) magnetische nichtachsensymmetrische transversale Feldkomponenten des Magnetfelds reduzieren wird, die **durch** jeden magnetischen Sub-Linsenmodul in einem Bereich oberhalb der oberen magnetischen Leiterplatte (41) erzeugt sind; und
eine untere magnetische Abschirmungsplatte (50), die unterhalb der unteren magnetischen Leiterplatte (42) mit einem unteren axialen Spalt dazwischen angeordnet ist und mehrere untere runde Öffnungen aufweist, die jeweils mit den mehreren Durchgangsrundlöchern fluchtend ausgerichtet sind, wobei der untere axiale Spalt evakuiert ist oder mit einem nicht magnetischen Material gefüllt ist, so dass die untere magnetische Abschirmungsplatte (50) die magnetischen nichtachsensymmetrischen transversalen Feldkomponenten des Magnetfelds reduzieren wird, die **durch** jeden magnetischen Sub-Linsenmodul in einem Bereich unterhalb der unteren magnetischen Leiterplatte (42) erzeugt sind.

2. Mehrachsige elektromagnetische zusammengesetzte Immersionsobjektivlinse zum Fokussieren mehrerer elektrisch geladener Partikelstrahlen auf eine Probe, aufweisend:
eine mehrachsige magnetische Immersionsobjektivlinse nach Anspruch 1;
und
eine flache Elektrode (70) unterhalb der unteren magnetischen Abschirmungsplatte (50) mit mehreren runden Öffnungen, wobei die mehreren runden Öffnungen jeweils mit den mehreren Innenpolstücken (311) fluchtend ausgerichtet sind,
so dass dadurch mehrere elektrostatische Sub-Linsenmodule in Verbindung mit der Probe gebildet werden, wobei die mehreren elektrostatischen Sub-Linsenmodule jeweils mit den mehreren magnetischen Sub-Linsenmodulen fluchtend ausgerichtet und mit diesen paarweise ausgelegt sind, wobei das elektrostatische Sub-Linsenmodul für jedes paarweise ausgelegte magnetische Sub-Linsenmodul und elektrostatische Sub-Linsenmodul das Innenpolstück, die flache Elektrode und die Probe als eine erste Elektrode, eine zweite Elektrode bzw. eine dritte Elektrode aufweist.

3. Mehrachsige magnetische Immersionsobjektivlinse nach Anspruch 1, wobei jeder erste radiale Spalt evakuiert ist oder mit einem nicht magnetischen Material gefüllt ist.

4. Mehrachsige elektromagnetische zusammengesetzte Immersionsobjektivlinse nach Anspruch 2, wobei jeder erste radiale Spalt evakuiert ist oder mit einem nicht magnetischen Material gefüllt ist.

5. Mehrachsige magnetische Immersionsobjektivlinse nach Anspruch 3, wobei jede obere runde Öffnung die Gestalt einer umgekehrten Senkbohrung aufweist, wobei sich für jedes magnetische Sub-Linsenmodul ein oberes Ende des Innenpolstücks (311) innerhalb eines unteren Abschnitts jeder der umgekehrten Senkbohrungen nach oben erstreckt, ohne eine Innenwand davon zu berühren, und einen Innendurchmesser (D1), der gleich oder größer als ein Innendurchmesser (D2) eines oberen Abschnitts der umgekehrten Senkbohrung ist, aufweist, sich untere Enden der Innen- und Außenpolstücke (311 und 312) innerhalb jeder unteren runden Öffnung abwärts erstrecken, ohne eine innere Seitenwand davon zu berühren, und an oder oberhalb einer Unterseite der unteren magnetischen Abschirmungsplatte (50) enden.

6. Mehrachsige magnetische Immersionsobjektivlinse nach Anspruch 5, ferner mit einer magnetischen Stufe, wobei die magnetische Stufe mit den Innen- und Außenpolstücken magnetisch gekoppelt ist, um das Magnetfeldeintauchen für die Probe zu verbessern.

7. Mehrachsige magnetische Immersionsobjektivlinse nach Anspruch 3, wobei sich die zweiten radialen Spalte für die mehreren magnetischen Sub-Linsenmodule voneinander unterscheiden.

8. Mehrachsige magnetische Immersionsobjektivlinse nach Anspruch 3, wobei die zweiten radialen Spalte für die mehreren magnetischen Sub-Linsenmodule zueinander identisch sind, und die mehreren ersten radialen Spalte Abmessungen aufweisen, die mit einem Abstand von jedem ersten radialen Spalt zu einer geometrischen Mittelachse des Paars magnetische Leiterplatten zunehmen.

9. Mehrachsige magnetische Immersionsobjektivlinse nach Anspruch 7, wobei die mehreren ersten radialen Spalte übereinstimmende Abmessungen aufweisen.

10. Mehrachsige elektromagnetische zusammengesetzte Immersionsobjektivlinse nach Anspruch 4, wobei sich für jedes magnetische Sub-Linsenmodul untere Enden der Innen- und Außenpolstücke innerhalb jeder der unteren runden Öffnungen abwärts erstrecken, ohne eine Innenwand davon zu berühren, und an oder oberhalb einer Unterseite der unteren magnetischen Abschirmungsplatte (50) enden, wobei die zweiten radialen Spalte für die mehreren magnetischen Sub-Linsenmodule zueinander identisch sind, und die mehreren ersten radialen Spalte Abmessungen aufweisen, die mit einem Abstand von jedem ersten radialen Spalt zu einer geometrischen Mittelachse des Paars magnetische Leiterplatten zunehmen.

11. Mehrachsige elektromagnetische zusammengesetzte Immersionsobjektivlinse nach Anspruch 4, wobei der obere Magnetring (311) für jeden der paarweise ausgelegten Magnetringe (311 und 312) zylindrisch oder trichterförmig mit einem schmalen unteren Ende im Inneren des unteren Magnetrings (312) gestaltet ist.

12. Mehrachsige elektromagnetische zusammengesetzte Immersionsobjektivlinse nach Anspruch 4, wobei die flache Elektrode in mehrere einzelne Segmente aufgeteilt ist, und jedes Segment eine der mehreren runden Öffnungen in der flachen Elektrode aufweist.

## Revendications

1. Lentille d'objectif à immersion magnétique multiaxiale pour focaliser une pluralité de faisceaux de particules chargées sur un échantillon (60), comprenant
une pluralité de modules de sous-lentille magnétique (300-M ; 300-ME) formés par une paire de plaques conductrices magnétiques parallèles (41, 42) et une bobine d'excitation commune (44) agencée entre la paire de plaques conductrices magnétiques parallèles pour fournir un flux magnétique à la pluralité modules de sous-lentille magnétique, la paire de plaques conductrices magnétiques parallèles comprenant une pluralité de trous ronds traversants par paires et une pluralité d'anneaux magnétiques (311, 312) par paires à l'intérieur des trous de ladite pluralité de trous ronds traversants et alignés avec ceux-ci, respectivement par paires,
dans laquelle, pour chaque paire de trous ronds traversants, un trou rond traversant supérieur dans une plaque conductrice magnétique supérieure (51) de ladite paire de plaques conductrices magnétiques parallèles est aligné avec un trou rond traversant inférieur dans une plaque conductrice magnétique inférieure (50) de ladite paire de plaques conductrices magnétiques parallèles, et pour chaque paire d'anneaux magnétiques à l'intérieur de chacune desdites paires de trous ronds traversants, un anneau magnétique supérieur (311) à l'intérieur dudit trou rond traversant supérieur est aligné avec un anneau magnétique inférieur (312) et s'étend vers le bas dans celui-ci, à l'intérieur dudit trou rond traversant inférieur,
**caractérisée en ce que**, dans chacune des plaques conductrices magnétiques (41, 42), les anneaux magnétiques sont alignés avec la pluralité de trous avec une pluralité de premiers intervalles radiaux (G1, G2),
dans laquelle, pour chaque paire de premiers intervalles radiaux formés par chacune desdites paires de trous ronds traversants et chacune desdites paires d'anneaux magnétiques, un premier intervalle radial supérieur (G1) est constitué entre une paroi latérale interne dudit trou rond traversant supérieur et une paroi latérale externe dudit anneau magnétique supérieur (311), et un premier intervalle radial inférieur (G2) est constitué entre une paroi latérale interne dudit trou rond traversant inférieur et une paroi latérale externe dudit anneau magnétique inférieur (312),
dans laquelle chaque module de sous-lentille magnétique comprend chacune desdites paires de trous ronds traversants, chacune desdites paires d'anneaux magnétiques qui s'y trouvent, et chacune desdites paires de premiers intervalles radiaux intermédiaires, et ledit anneau magnétique supérieur et ledit anneau magnétique inférieur de chacune desdites paires d'anneaux magnétiques fonctionnent respectivement comme une pièce polaire interne et une pièce polaire externe de chacun desdits modules de sous-lentille magnétique,
**caractérisée en outre par** :
un deuxième intervalle radial (G3) formé entre des extrémités de fond dudit anneau magnétique supérieur (311, par rapport à 32) et ledit anneau magnétique inférieur (312, par rapport à 33) dans chaque dit module de sous-lentille magnétique, dans laquelle ladite extrémité inférieure dudit anneau magnétique supérieur (311) s'étend vers le bas à travers ledit anneau magnétique inférieur (312), dans laquelle ledit deuxième intervalle radial (G3) présente une taille supérieure aux tailles desdites paires de premiers intervalles radiaux (G1 et G2, par rapport à 34 et 35) et est sous vide ou rempli d'un matériau non magnétique,
une plaque de blindage magnétique supérieure (51) située au-dessus de ladite plaque conductrice magnétique supérieure (41) avec un intervalle axial supérieur intermédiaire et comportant une pluralité d'ouvertures circulaires supérieures alignées respectivement avec ladite pluralité de trous ronds traversants, dans laquelle ledit intervalle axial supérieur est sous vide ou rempli d'un matériau non magnétique de telle sorte que ladite plaque de blindage magnétique supérieure (51) réduira les composantes de champ magnétique transversal non axialement symétriques dudit champ magnétique généré par chaque dit module de sous-lentille magnétique dans une zone située au-dessus de ladite plaque conductrice magnétique supérieure (41) ; et
une plaque de blindage magnétique inférieure (50) située en dessous de ladite plaque conductrice magnétique inférieure (42) avec un intervalle axial inférieur intermédiaire et comportant une pluralité d'ouvertures circulaires inférieures alignées respectivement avec ladite pluralité de trous ronds traversants, dans laquelle ledit intervalle axial inférieur est sous vide ou rempli d'un matériau non magnétique de telle sorte que ladite plaque de blindage magnétique inférieure (50) réduira lesdites composantes de champ magnétique transversal non axialement symétriques dudit champ magnétique généré par chaque dit module de sous-lentille magnétique dans une zone située en dessous de ladite plaque conductrice magnétique inférieure (42).

2. Lentille d'objectif à immersion composée électromagnétique multiaxiale pour focaliser une pluralité de faisceaux de particules chargées sur un échantillon, comprenant :
une lentille d'objectif à immersion magnétique multiaxiale selon la revendication 1 ; et
une électrode plane (70) sous ladite plaque de blindage magnétique inférieure (50) comportant une pluralité d'orifices circulaires, dans laquelle les orifices de ladite pluralité d'orifices circulaires sont respectivement alignés avec ladite pluralité de pièces polaires internes (311),
formant ainsi une pluralité de modules de sous-lentille électrostatique conjointement audit échantillon, dans laquelle les modules de ladite pluralité de modules de sous-lentille électrostatique sont respectivement alignés et appariés avec les modules de ladite pluralité de modules de sous-lentille magnétique, dans laquelle, pour chaque module de sous-lentille magnétique et module de sous-lentille électrostatique appariés, ledit module de sous-lentille électrostatique comprend ladite pièce polaire interne, ladite électrode plane et ledit échantillon respectivement comme première électrode, deuxième électrode et troisième électrode.

3. Lentille d'objectif à immersion magnétique multiaxiale selon la revendication 1 dans laquelle chaque premier intervalle radial est sous vide ou rempli d'un matériau non magnétique.

4. Lentille d'objectif à immersion composée électromagnétique multiaxiale selon la revendication 2 dans laquelle chaque premier intervalle radial est sous vide ou rempli d'un matériau non magnétique.

5. Lentille d'objectif à immersion magnétique multiaxiale selon la revendication 3 dans laquelle chaque ouverture circulaire supérieure présente une forme de lamage inversé, dans laquelle, pour chaque dit module de sous-lentille magnétique, une extrémité supérieure de ladite pièce polaire interne (311) s'étend vers le haut à l'intérieur d'une portion inférieure de chaque dit lamage inversé sans toucher une paroi interne correspondante, et présente un diamètre interne (D1) supérieur ou égal à un diamètre interne (D2) d'une portion supérieure dudit lamage inversé, et des extrémités de fond desdites pièces polaires interne et externe (311 et 312) s'étendent vers le bas à l'intérieur de chaque dite ouverture circulaire inférieure sans toucher une paroi latérale interne correspondante et s'arrêtent au niveau ou au-dessus d'une surface de fond de ladite plaque de blindage magnétique inférieure (50).

6. Lentille d'objectif à immersion magnétique multiaxiale selon la revendication 5 comprenant en outre un étage magnétique, dans laquelle ledit étage magnétique se couple magnétiquement auxdites pièces polaires interne et externe pour augmenter ladite immersion de champ magnétique pour ledit échantillon.

7. Lentille d'objectif à immersion magnétique multiaxiale selon la revendication 3 dans laquelle, pour la pluralité de modules de sous-lentille magnétique, lesdits deuxièmes intervalles radiaux ne sont pas identiques entre eux.

8. Lentille d'objectif à immersion magnétique multiaxiale selon la revendication 3 dans laquelle, pour ladite pluralité de modules de sous-lentille magnétique, lesdits deuxièmes intervalles radiaux sont identiques entre eux, et les intervalles de ladite pluralité de premiers intervalles radiaux présentent des tailles croissantes avec la distance entre chaque premier intervalle radial et un axe central géométrique de la paire de plaques conductrices magnétiques parallèles.

9. Lentille d'objectif à immersion magnétique multiaxiale selon la revendication 7 dans laquelle les intervalles de ladite pluralité de premiers intervalles radiaux présentent des tailles égales.

10. Lentille d'objectif à immersion composée électromagnétique multiaxiale selon la revendication 4 dans laquelle, pour chaque dit module de sous-lentille magnétique, les extrémités de fond desdites pièces polaires interne et externe s'étendent vers le bas à l'intérieur de chaque dite ouverture circulaire inférieure sans toucher une paroi interne correspondante et s'arrêtent au niveau ou au-dessus d'une surface de fond de ladite plaque de blindage magnétique inférieure (50), dans laquelle, pour la pluralité de modules de sous-lentille magnétique, lesdits deuxièmes intervalles radiaux sont identiques entre eux, et les intervalles de ladite pluralité de premiers intervalles radiaux présentent des tailles croissantes avec la distance entre chaque premier intervalle radial et un axe central géométrique de la paire de plaques conductrices magnétiques parallèles.

11. Lentille d'objectif à immersion composée électromagnétique multiaxiale selon la revendication 4 dans laquelle, pour chaque paire d'anneaux magnétiques (311 et 312), ledit anneau magnétique supérieur (311) présente une forme cylindrique ou d'entonnoir avec une extrémité inférieure étroite à l'intérieur dudit anneau magnétique inférieur (312).

12. Lentille d'objectif à immersion composée électromagnétique multiaxiale selon la revendication 4 dans laquelle ladite électrode plane est divisée en une pluralité de segments individuels, et chaque segment comprend un orifice de ladite pluralité d'orifices circulaires dans ladite électrode plane.
